# EUROPEAN PATENT APPLICATION

(11) **EP 4 503 350 A1**
(43) Date of publication of application: **05.02.2025**
(21) Application number: 22933605.2
(22) Date of filing: 27.10.2022
(51) Int. Cl.: H01S 3/10, G02B 26/00

(54) **LIGHT SOURCE DEVICE**

(30) Priority: 24.03.2022 JP 2022048296
(71) Applicant: SCREEN Holdings Co., Ltd., Kyoto-shi, Kyoto 602-8585 (JP)
(72) Inventor: ASHIDA, Yuki, Kyoto-shi, Kyoto 602-8585 (JP)
(74) Representative: Goddar, Heinz J.
(86) International application number: PCT/JP2022/040135
(87) International publication number: WO 2023/181475

(57) **Abstract**

In order to provide a light source apparatus that can quickly change wavelengths of emission light, a light source apparatus includes an optical amplifier, a spectroscopic element, a spatial phase modulating element, and a controller. The optical amplifier amplifies and releases light. The spectroscopic element separates the light from the optical amplifier according to wavelengths. The spatial phase modulating element includes a base part and a plurality of grating elements that reflect the light separated by the spectroscopic element. The spatial phase modulating element relatively displaces at least a part of grating elements with respect to the base part and thereby performs phase modulation on the light separated by the spectroscopic element, and emits diffracted light along an incident optical path from the spectroscopic element regarding a part of the wavelengths within a wavelength range of the light separated by the spectroscopic element. The controller controls displacement of the plurality of grating elements with respect to the base part. The diffracted light emitted from the spatial phase modulating element generates the light having the part of the wavelengths in the spectroscopic element, and the light having the part of the wavelengths is amplified by the optical amplifier and is subsequently released toward the spectroscopic element. The light having the part of the wavelengths subjected to a plurality of times of amplification by the optical amplifier is output.

## Description

### TECHNICAL FIELD

The present invention relates to a light source apparatus that can change wavelengths of emission light.

### BACKGROUND ART

Light sources, such as laser light sources, that can change wavelengths of emission light are used in a field of optical communication, a field of inspection apparatus, and the like.

For example, as an example of the inspection apparatus, optical coherence tomography (OCT) is known, which allows acquisition of information related to tomographic images of subjects in a non-invasive manner. In swept source OCT (SS-OCT) as a type of OCT, a light source that changes wavelengths of emission light timewise in a wide band is used, and intensity of light obtained by causing interference between sample light and reference light is acquired regarding each of the wavelengths. Thus, in SS-OCT, a wavelength swept light source (frequency swept light source) that can sweep the wavelengths of the output light in a wide band is used.

Examples of the wavelength swept light source include an external cavity wavelength swept light source that combines a gain medium that generates light and an oscillating mirror of micro electronic mechanical systems (MEMS), and the like (for example, Patent Document 1 and the like). In the external cavity wavelength swept light source, light having wavelengths in a certain range emitted from the gain medium is separated by a diffraction grating or the like according to the wavelengths, and light having a desired wavelength is caused to be selectively reflected and sent back to the gain medium through the use of reciprocating motion of the oscillating mirror of the MEMS, to thereby allow the light to be amplified and the wavelengths of the light emitted from the light source to be swept.

### PRIOR ART DOCUMENTS

### PATENT DOCUMENT

Patent Document 1: Japanese Patent Application Laid-Open No. 2017-148109

### SUMMARY

### PROBLEM TO BE SOLVED BY THE INVENTION

However, in the external cavity wavelength swept light source using the oscillating mirror of the MEMS, for example, time required for sweeping of the wavelengths of the light emitted from the light source is in accordance with the period of oscillation of the oscillating mirror of the MEMS. In other words, the rate of changing the wavelengths of the light emitted from the light source is limited depending on the period of oscillation of the oscillating mirror of the MEMS.

Further, in the external cavity wavelength swept light source using the oscillating mirror of the MEMS, for example, due to oscillation of the oscillating mirror of the MEMS, the wavelengths of the light emitted from the light source can only be changed sequentially in a direction from a maximum wavelength toward a minimum wavelength in a predetermined wavelength range or in a direction from the minimum wavelength toward the maximum wavelength.

Thus, regarding the external cavity wavelength swept light source, for example, there is room for improvement in quickly changing the wavelengths of emission light.

The present invention is made in view of the problem described above, and has an object to provide a light source apparatus that can quickly change wavelengths of emission light.

### MEANS TO SOLVE THE PROBLEM

In order to solve the problem described above, a light source apparatus according to a first aspect includes an optical amplifier, a spectroscopic element, a spatial phase modulating element, and a controller. The optical amplifier is configured to amplify and release light. The spectroscopic element is configured to separate the light released from the optical amplifier according to wavelengths. The spatial phase modulating element includes a base part and a plurality of grating elements configured to reflect the light separated by the spectroscopic element. The spatial phase modulating element is configured to relatively displace at least a part of grating elements out of the plurality of grating elements with respect to the base part and thereby perform phase modulation on the light separated by the spectroscopic element, and emit diffracted light toward the spectroscopic element along an incident optical path from the spectroscopic element regarding a part of the wavelengths within a wavelength range of the light separated by the spectroscopic element. The controller is configured to control displacement of the plurality of grating elements with respect to the base part. The diffracted light emitted from the spatial phase modulating element generates the light having the part of the wavelengths in the spectroscopic element, and the light having the part of the wavelengths is amplified by the optical amplifier and is subsequently released toward the spectroscopic element. The light having the part of the wavelengths subjected to a plurality of times of amplification by the optical amplifier is output.

A light source apparatus according to a second aspect is the light source apparatus according to the first aspect. The optical amplifier includes a semiconductor optical amplifier, a booster optical amplifier, or a semiconductor laser.

A light source apparatus according to a third aspect is the light source apparatus according to the first or second aspect. The spectroscopic element includes a diffraction grating.

A light source apparatus according to a fourth aspect is the light source apparatus according to any one of the first to third aspects. The controller changes a pattern of displacement of the plurality of grating elements with respect to the base part using the spatial phase modulating element from a first pattern to a second pattern, and thereby switches from a state in which the part of the wavelengths includes a first wavelength to a state in which the part of the wavelengths includes a second wavelength different from the first wavelength.

A light source apparatus according to a fifth aspect is the light source apparatus according to any one of the first to third aspects. The part of the wavelengths includes a plurality of wavelengths being different and apart from each other.

A light source apparatus according to a sixth aspect is the light source apparatus according to the fifth aspect. The controller changes a pattern of displacement of the plurality of grating elements with respect to the base part using the spatial phase modulating element from a first pattern to a second pattern, and thereby switches from a state in which the plurality of wavelengths include a first-A wavelength and a first-B wavelength to a state in which the plurality of wavelengths include a second-A wavelength different from the first-A wavelength and a second-B wavelength different from the first-B wavelength.

A light source apparatus according to a seventh aspect is the light source apparatus according to any one of the first to sixth aspects, and further includes a first light guide part, an optical path change optical system, and a second light guide part. The first light guide part guides the light released from the optical amplifier toward the optical path change optical system. The optical path change optical system guides the light that has been released from the optical amplifier and has passed through the first light guide part toward the spectroscopic element, and guides the light having the part of the wavelengths generated in the spectroscopic element according to the diffracted light emitted from the spatial phase modulating element to the second light guide part. The second light guide part includes a first light output part configured to output a part of the light out of the light guided to the second light guide part by the optical path change optical system to an outside of the second light guide part, and a light guide portion configured to guide a rest of the light except the part of the light out of the light guided to the second light guide part by the optical path change optical system toward the optical amplifier.

A light source apparatus according to an eighth aspect is the light source apparatus according to any one of the first to sixth aspects, and further includes a third light guide part and a partially reflecting optical system. The third light guide part is configured to guide the light released from a first end surface of the optical amplifier toward the spectroscopic element, and guide the light having the part of the wavelengths generated in the spectroscopic element according to the diffracted light emitted from the spatial phase modulating element toward the first end surface of the optical amplifier. The partially reflecting optical system is configured to allow a part of the light out of the light released from a second end surface of the optical amplifier to be transmitted through the partially reflecting optical system and output the part of the light, and reflect a rest of the light except the part of the light out of the light released from the second end surface of the optical amplifier toward the second end surface.

A light source apparatus according to a ninth aspect is the light source apparatus according to any one of the first to eighth aspects. The plurality of grating elements include a plurality of ribbon-like parts. Each of the plurality of ribbon-like parts has an elongated ribbon-like shape extending along a first direction and flexibility, and includes a reflection part including a light reflecting surface on an opposite side of the base part. The plurality of ribbon-like parts are arrayed along a second direction perpendicular to the first direction. The reflection part of each of the plurality of ribbon-like parts faces the base part across a space. Each of the plurality of ribbon-like parts includes a connection part connected to the base part at both end portions in the first direction. The base part includes an electrode facing the reflection part. The controller adjusts a potential difference to be applied between the reflection part of each of the plurality of ribbon-like parts and the electrode, and thereby deflects the plurality of ribbon-like parts using an electrostatic force between the reflection part of each of the plurality of ribbon-like parts and the electrode, and controls displacement of the reflection part of each of the plurality of ribbon-like parts with respect to the base part.

A light source apparatus according to a tenth aspect is the light source apparatus according to any one of the first to eighth aspects. The spatial phase modulating element includes a plurality of reflective elements arrayed in a matrix shape. Each of the plurality of reflective elements includes a movable reflection part facing the base part across a space and including a light reflecting surface on an opposite side of the base part, and a support part being configured to support each of a plurality of portions of the movable reflection part, being connected to the base part, and having flexibility. The plurality of grating elements include the movable reflection part of each of the plurality of reflective elements. The base part includes an electrode facing the movable reflection part. In each of the plurality of reflective elements, the controller adjusts a potential difference to be applied between the movable reflection part and the electrode and thereby deflects the support part using an electrostatic force between the movable reflection part and the electrode, and controls displacement of the movable reflection part with respect to the base part.

### EFFECTS OF THE INVENTION

In the light source apparatus according to any of the first to tenth aspects, for example, by changing the pattern of displacement of the plurality of grating elements with respect to the base part, the light of the part of the wavelengths to be selectively sent back to the spectroscopic element out of the light in the predetermined wavelength range separated by the spectroscopic element can be quickly changed. As a result, for example, the wavelengths of the output light output from the light source apparatus after a plurality of times of amplification can be quickly switched. Therefore, for example, the wavelengths of the light emitted by the light source apparatus can be quickly changed.

In the light source apparatus according to the fourth aspect, for example, by changing the pattern of displacement of the plurality of grating elements with respect to the base part from the first pattern to the second pattern, the wavelengths of the light output from the light source apparatus can be randomly changed. As a result, for example, the wavelengths of the light emitted by the light source apparatus can be quickly changed.

In the light source apparatus according to any of the fifth and sixth aspects, for example, the wavelengths of the light selectively sent back to the spectroscopic element out of the light in the predetermined wavelength range separated by the spectroscopic element include the plurality of wavelengths being different and apart from each other, and therefore the light having the plurality of wavelengths being different and apart from each other can be simultaneously output from the light source apparatus.

In the light source apparatus according to the sixth aspect, for example, by changing the pattern of displacement of the plurality of grating elements with respect to the base part from the first pattern to the second pattern, the plurality of wavelengths of the light simultaneously output from the light source apparatus can be randomly changed. As a result, for example, the plurality of wavelengths of the light simultaneously emitted by the light source apparatus can be quickly changed.

### BRIEF DESCRIPTION OF DRAWINGS

FIG. 1 is a diagram schematically illustrating an example of a configuration of a light source apparatus according to a first embodiment.
FIG. 2 is a plan view schematically illustrating an example of a configuration of a grating light valve as a spatial phase modulating element.
FIG.3 is a cross-sectional diagram schematically illustrating an example of a configuration of the grating light valve as the spatial phase modulating element.
FIG.4 is a cross-sectional diagram schematically illustrating an example of a configuration of the grating light valve as the spatial phase modulating element.
FIG.5 is a diagram schematically illustrating an example of operation of the grating light valve as the spatial phase modulating element.
FIG.6 is a diagram schematically illustrating an example of operation of the grating light valve as the spatial phase modulating element.
FIG.7 is a diagram schematically illustrating an example of operation of the grating light valve as the spatial phase modulating element.
FIG.8 is a diagram schematically illustrating an example of a relationship between an optical path of incident light and an optical path of diffracted light as emission light in the spatial phase modulating element.
FIG.9 is a diagram schematically illustrating an example of a relationship between an optical path of incident light and an optical path of diffracted light as emission light in the spatial phase modulating element.
FIG.10 is a diagram schematically illustrating an example of a relationship between an optical path of incident light and an optical path of diffracted light as emission light in the spatial phase modulating element.
FIG.11 is a graph schematically showing an example of switching of wavelengths of output light output from the light source apparatus.
FIG.12 is a graph schematically showing an example of a relationship between wavelengths and intensity regarding output light having a plurality of wavelengths output from the light source apparatus.
FIG.13 is a cross-sectional diagram schematically illustrating an example of a first-A pattern relating to a surface shape of a blazed diffraction grating functionally implemented in the spatial phase modulating element.
FIG.14 is a cross-sectional diagram schematically illustrating an example of a first-B pattern relating to the surface shape of the blazed diffraction grating functionally implemented in the spatial phase modulating element.
FIG.15 is a diagram for illustrating an example of a method of generating a combined pattern for sending light having a plurality of wavelengths back to a spectroscopic element regarding the surface shape of the blazed diffraction grating functionally implemented in the spatial phase modulating element.
FIG.16 is a cross-sectional diagram schematically illustrating an example of the combined pattern relating to the surface shape of the blazed diffraction grating functionally implemented in the grating light valve as the spatial phase modulating element.
FIG.17 is a graph schematically showing an example of switching of a plurality of wavelengths of output light output from the light source apparatus.
FIG. 18 is a diagram schematically illustrating a configuration of a light source apparatus according to a modification.
FIG. 19 is a plan view schematically illustrating an example of a configuration of a planar light valve.
FIG.20 is a cross-sectional diagram schematically illustrating a configuration of a single reflective element and a base part in the planar light valve.
FIG.21 is a cross-sectional diagram schematically illustrating a configuration of the single reflective element and the base part in the planar light valve.

### DESCRIPTION OF EMBODIMENT

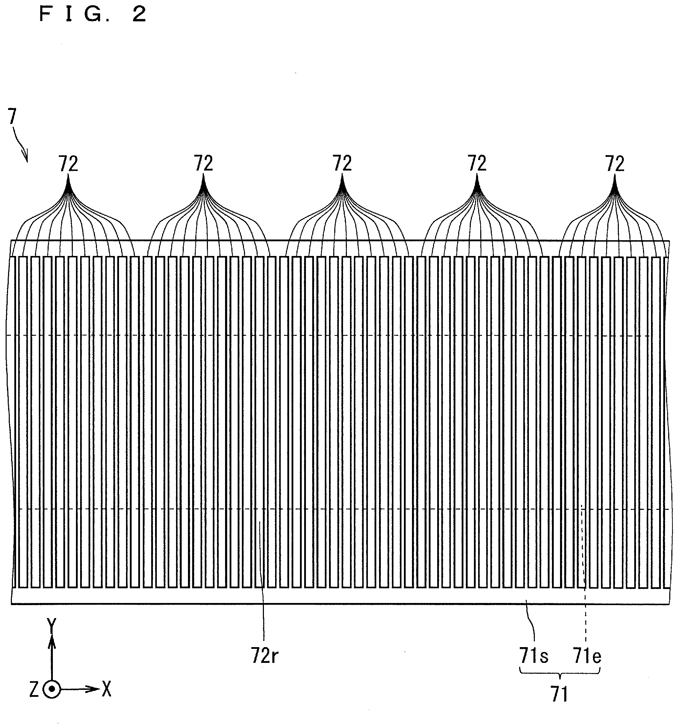

Various embodiments of the present invention will be described below with reference to the accompanying drawings. Constituent elements described in these embodiments are merely examples, and the scope of the present invention is not to be limited only to those. In the drawings, parts having similar configurations and functions are denoted by the same reference signs, and overlapping description will be omitted in the following description. Further, in the drawings, in order to facilitate understanding, dimensions and the number of each part are illustrated in an exaggerated or simplified manner as necessary. In each of the drawings, in order to describe positional relationships and the like of elements, FIG. 2 to FIG. 10, FIG. 13 to FIG. 16, and FIG. 19 to FIG. 21 are each provided with a right-handed XYZ orthogonal coordinate system. Here, the X-axis and the Y-axis extend in a direction along a diffraction grating surface (also referred to as a grating surface) P0 of a spatial phase modulating element 7 to be described later, and the Z-axis extends in a direction along a normal line to the grating surface P0. Further, in the following description, a direction of the point of an arrow is defined as a + (plus) direction, and a direction opposite thereto is defined as a - (minus) direction.

Unless otherwise specifically noted, an expression indicating a relative or absolute positional relationship (for example, "in a direction", "along a direction", "parallel", "orthogonal", "center", "concentric", "coaxial", or the like) does not only precisely indicate the positional relationship, but also indicates a state relatively displaced with respect to an angle or a distance as long as tolerance or comparable functionality is achieved. Unless otherwise specifically noted, an expression indicating an equivalent state (for example, "same", "equivalent", "homogeneous", or the like) does not only quantitatively precisely indicate the equivalent state, but also indicates a state in which there is a difference with which tolerance or comparable functionality is achieved. Unless otherwise specifically noted, an expression indicating a shape (for example, a "quadrilateral shape", a "cylindrical shape", or the like) does not only geometrically precisely indicate the shape, but also indicates a shape having unevenness, a chamfer, or the like, for example, as long as a comparable effect is achieved. An expression "to be provided with", "to be equipped with", "to comprise", "to include", or "to have" one constituent element is not an exclusive expression that excludes presence of another constituent element. Unless otherwise specifically noted, "on/above" and "below" may include not only a case where two elements are in contact with each other but also a case where two elements are separate from each other. Unless otherwise specifically noted, "to cause movement in a specific direction" may include not only a case of causing movement in parallel with the specific direction but also a case of causing movement in a direction having a component of the specific direction.

### <1. First Embodiment>

### <1-1. Configuration of Light Source Apparatus>

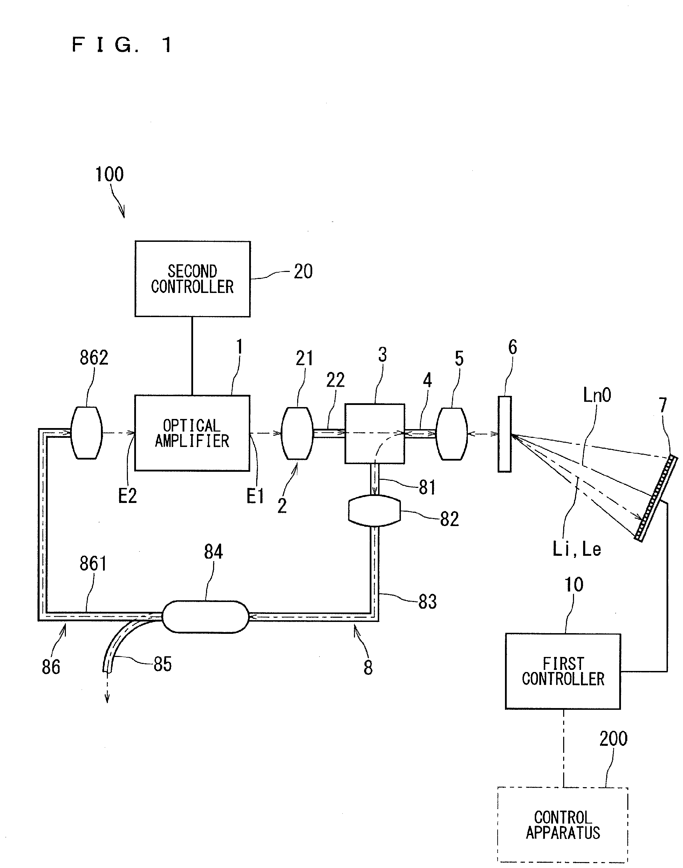

FIG. 1 is a diagram schematically illustrating an example of a configuration of a light source apparatus 100 according to a first embodiment. In FIG. 1, a traveling direction of light is indicated by an arrow shown in a thin one-dot chain line.

The light source apparatus 100 has a configuration of an external cavity light source apparatus, which can selectively send light having a desired wavelength out of light emitted from an optical amplifier back to the optical amplifier using a configuration provided outside the optical amplifier, to thereby amplify light having a desired wavelength and output the light.

The light source apparatus 100 includes an optical amplifier 1, a spectroscopic element 6, a spatial phase modulating element 7, and a first controller 10. Further, the light source apparatus 100 includes a second controller 20, for example. In the first embodiment, the light source apparatus 100 includes a first light guide part 2, an optical path change optical system 3, and a second light guide part 8. In the example of FIG. 1, the light source apparatus 100 includes an optical fiber 4 being a light transmission part that has a function of transmitting light and a collimator lens 5 being an optical lens, which are disposed between the optical path change optical system 3 and the spectroscopic element 6.

### «Optical Amplifier 1»

The optical amplifier 1 amplifies and releases light. The optical amplifier 1 releases the light toward the spectroscopic element 6, for example. As the optical amplifier 1, an optical gain medium (also referred to as an optical gain medium) that amplifies light is used, such as a semiconductor laser (laser diode (LD)), a semiconductor optical amplifier (SOA), or a booster optical amplifier (BOA), for example.

Further, the optical amplifier 1 generates light in response to application of a voltage, for example. The optical amplifier 1 is driven when an applied voltage is controlled by control of the second controller 20, for example. The optical amplifier 1 emits light having intensity in a predetermined wavelength range, for example. The predetermined wavelength range is set to a range having a width of approximately from 50 nanometers (nm) to 150 nm, for example. The light having intensity in the predetermined wavelength range may be visible light or may be invisible light, for example. As the invisible light, near-infrared light, ultraviolet light, far-infrared light, or the like is used, for example. The light emitted from the optical amplifier 1 may include light having intensity in a wavelength other than the predetermined wavelength range, for example. In the example of FIG. 1, light released from one end surface (also referred to as a first end surface) E1 of the optical amplifier 1 passes through the first light guide part 2, the optical path change optical system 3, the optical fiber 4, and the collimator lens 5 in the mentioned order and is then radiated to the spectroscopic element 6.

### <<First Light Guide Part 2>>

The first light guide part 2 guides the light released from the optical amplifier 1 toward the optical path change optical system 3. The first light guide part 2 includes a collimator lens 21 being an optical lens and an optical fiber 22 being a light transmission part, for example. In the example of FIG. 1, light released from the first end surface E1 of the optical amplifier 1 passes through the collimator lens 21 and the optical fiber 22 in the mentioned order and then enters the optical path change optical system 3.

### «Optical Path Change Optical System 3»

The optical path change optical system 3 guides the light that has been released from the optical amplifier 1 and has passed through the first light guide part 2 toward the spectroscopic element 6. Further, the optical path change optical system 3 guides light from the spectroscopic element 6 to the second light guide part 8. The light from the spectroscopic element 6 is light generated in the spectroscopic element 6 according to diffracted light emitted from the spatial phase modulating element 7, for example. As the optical path change optical system 3, an optical system is used which is configured using an optical circulator, a polarizing beam splitter (PBS), or the like, for example.

In the example of FIG. 1, light that has been released from the optical amplifier 1 and guided toward the spectroscopic element 6 by the optical path change optical system 3 passes through the optical fiber 4 and the collimator lens 5 in the mentioned order and is then radiated to the spectroscopic element 6. Further, light generated in the spectroscopic element 6 according to diffracted light emitted from the spatial phase modulating element 7 passes through the collimator lens 5 and the optical fiber 4 in the mentioned order and then enters the optical path change optical system 3.

### <<Spectroscopic Element 6>>

The spectroscopic element 6 separates the light released from the optical amplifier 1 according to wavelengths. In the example of FIG. 1, the spectroscopic element 6 separates light that has been released from the optical amplifier 1, has passed through the first light guide part 2, the optical path change optical system 3, the optical fiber 4, and the collimator lens 5 in the mentioned order and been then radiated to the spectroscopic element 6, according to wavelengths. The spectroscopic element 6 emits light having intensity in a predetermined wavelength range that constitutes the light released from the optical amplifier 1 at angles according to wavelengths. In other words, the spectroscopic element 6 disperses the light having intensity in the predetermined wavelength range that constitutes the light released from the optical amplifier 1 according to wavelengths. As the spectroscopic element 6, a diffraction grating is used. In the example of FIG. 1, a transmission type diffraction grating is used as the spectroscopic element 6; however, this is not restrictive, and a reflection type diffraction grating may be used as the spectroscopic element 6. Further, as the spectroscopic element 6, another spectroscopic element such as a prism may be used, for example.

The light separated in the spectroscopic element 6 is radiated to the spatial phase modulating element 7. Thus, regarding the light having intensity in the predetermined wavelength range, the light is radiated to the spatial phase modulating element 7 at angles according to wavelengths. Here, an optical path serving as a reference out of optical paths of the light separated in the spectroscopic element 6 and then radiated from the spectroscopic element 6 to the spatial phase modulating element 7 is defined as a reference optical path Ln0. As the reference optical path Ln0, the central optical path of the optical paths of the light separated in the spectroscopic element 6 and then radiated from the spectroscopic element 6 to the spatial phase modulating element 7 is employed, for example. As the central optical path, regarding the light having intensity in the predetermined wavelength range, an optical path at the central angle within an angle range of the light emitted from the spectroscopic element 6 is used.

Further, the spectroscopic element 6 generates light according to diffracted light emitted from the spatial phase modulating element 7. The light is emitted toward the optical path change optical system 3. In the example of FIG. 1, light generated in the spectroscopic element 6 according to diffracted light emitted from the spatial phase modulating element 7 passes through the collimator lens 5 and the optical fiber 4 in the mentioned order and then enters the optical path change optical system 3.

### «Spatial Phase Modulating Element 7»

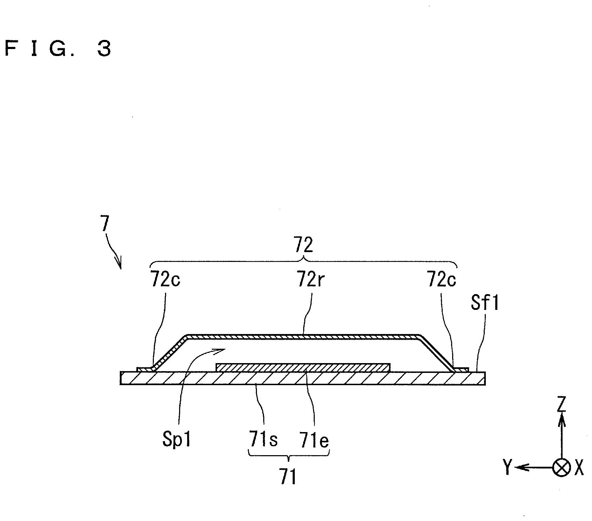

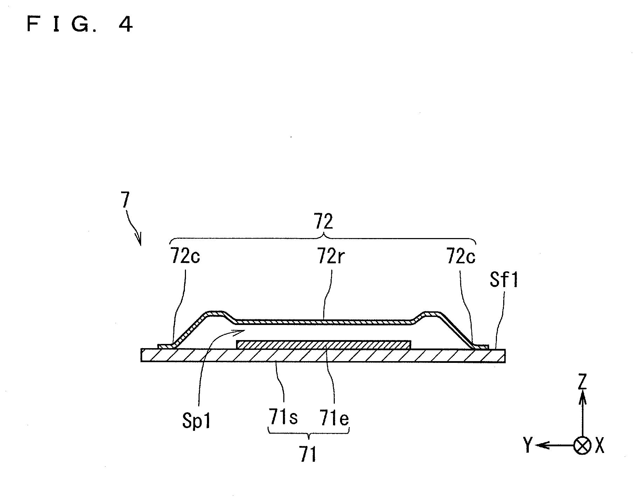

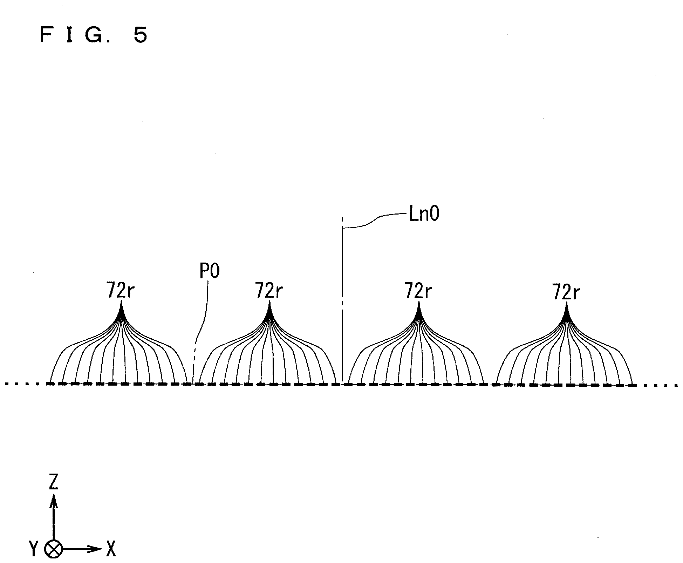

The spatial phase modulating element 7 performs phase modulation on the light radiated from the spectroscopic element 6. Consequently, the spatial phase modulating element 7 can emit diffracted light toward the spectroscopic element 6, for example. As the spatial phase modulating element 7, a grating light valve being a type of optical phased array, which is illustrated in FIG. 2 to FIG. 4, is used, for example. FIG. 2 is a plan view schematically illustrating an example of a configuration of the grating light valve. FIG. 2 schematically illustrates a part of a configuration of the grating light valve. FIG. 3 and FIG. 4 are each a cross-sectional diagram schematically illustrating an example of a configuration of the grating light valve. FIG. 5 to FIG. 7 are each a diagram schematically illustrating an example of operation of the grating light valve. In FIG. 2 to FIG. 7, a first direction along a main surface (also referred to as a first main surface) Sf1 of a substrate 71s constituting the grating light valve on the +Z direction side is the +Y direction, a second direction along the first main surface Sf1 and perpendicular to the +Y direction is the +X direction, and a third direction along the normal line to the first main surface Sf1 is the +Z direction.

The grating light valve includes a base part 71 and a plurality of ribbon-shaped parts (also referred to as ribbon-like parts or ribbons) 72 as a plurality of grating elements that reflect the light separated by the spectroscopic element 6, for example.

The base part 71 includes the substrate 71s and an electrode (also referred to as a reference electrode) 71e, for example. As the substrate 71s, a plate-like substrate such as a silicon substrate is used, for example. The reference electrode 71e is located along the first main surface Sf1 of the substrate 71s. As the reference electrode 71e, a metal film formed on the first main surface Sf1 of the substrate 71s is used, for example.

The plurality of ribbons 72 are located on the first main surface Sf1 of the substrate 71s. As each of the plurality of ribbons 72, a fine structure configured with an amorphous silicon nitride film or the like is used, for example. The plurality of ribbons 72 are arrayed along the X direction. The number of the plurality of ribbons 72 is set to approximately from 2000 to 4000, for example. More specifically, the number of the plurality of ribbons 72 is set to approximately 3000, for example. Here, the plurality of ribbons 72 are not in contact with each other. In other words, a fine clearance is present between two adjacent ribbons 72 of the plurality of ribbons 72.

Each of the plurality of ribbons 72 has an elongated ribbon-like shape extending along the Y direction. For example, as illustrated in FIG. 2, in plan view, each of the plurality of ribbons 72 has a rectangular shape having a transverse direction along the X direction and a longitudinal direction along the Y direction. The length (also referred to as width) of each ribbon 72 in the transverse direction is set to approximately from 2 micrometers (µm) to 25.5 µm, for example, and the length of each ribbon 72 in the longitudinal direction is set to approximately from 1 millimeter (mm) to 3 mm, for example.

Each of the plurality of ribbons 72 includes a reflection part 72r and connection parts 72c, for example. In each ribbon 72, the reflection part 72r is located at the center in the Y direction, and the connection parts 72c are located at both ends in the Y direction. In other words, in each ribbon 72, in the Y direction, the connection part (also referred to as a first connection part) 72c, the reflection part 72r, and the connection part (also referred to as a second connection part) 72c are located in the mentioned order.

The reflection part 72r includes a surface (also referred to as a light reflecting surface) that specularly reflects light on an opposite side of the base part 71. For example, the light reflecting surface is a surface in parallel to the XY plane. For example, the surface of each ribbon 72 has a configuration of being covered with a metal thin film, such as aluminum, that specularly reflects light. Consequently, for example, the surface of the reflection part 72r of each ribbon 72 on the opposite side of the base part 71 has a function as the light reflecting surface. Here, for example, owing to the reflection part 72r including the light reflecting surface, the reflection part 72r of each ribbon 72 can reflect the light separated by the spectroscopic element 6. In other words, for example, the plurality of ribbons 72 as the plurality of grating elements can reflect the light separated by the spectroscopic element 6. Further, the metal thin film constituting the surface of each ribbon 72 has a function as an electrode (also referred to as a movable electrode).

The connection parts 72c are parts connected to the base part 71. For example, as illustrated in FIG. 3, each of the plurality of ribbons 72 includes the connection parts 72c connected to the base part 71 at both end portions in the Y direction. In other words, for example, each of the plurality of ribbons 72 is connected to the first main surface Sf1 of the base part 71 at both end portions in the Y direction.

Here, the reflection part 72r of each of the plurality of ribbons 72 faces the base part 71 across a space Sp1. Further, the reflection part 72r of each ribbon 72 faces the reference electrode 71e of the base part 71 across the space Sp1. In other words, the reference electrode 71e of the base part 71 faces the reflection part 72r of each of the plurality of ribbons 72. From another point of view, for example, each of the plurality of ribbons 72 is provided to stretch over the substrate 71s in a manner of crossing the reference electrode 71e without coming in contact with the reference electrode 71e.

Each of the plurality of ribbons 72 has flexibility. Here, for example, when a potential difference is applied between the ribbon 72 having a function as the movable electrode and the reference electrode 71e, an electrostatic force that attracts the reflection part 72r to the reference electrode 71e is generated between the reflection part 72r and the reference electrode 71e. The electrostatic force deflects the ribbon 72. FIG. 3 illustrates the ribbon 72 in an undeflected state (also referred to as a reference state), and FIG. 4 illustrates the ribbon 72 in a deflected state. As illustrated in FIG. 3 and FIG. 4, when being deflected, the ribbon 72 is displaced in the Z direction. Here, for example, when the ribbon 72 is deflected with reference to a position of the reflection part 72r in the reference state in which the ribbon 72 is not deflected, the reflection part 72r is displaced in the -Z direction.

The grating light valve as the spatial phase modulating element 7 deflects the ribbon 72 using the electrostatic force according to a signal from the first controller 10, and thereby displaces the ribbon 72 by a displacement amount according to the signal, for example. The grating light valve includes a complementary metal oxide semiconductor (CMOS) driver (not illustrated) or the like for individually applying a potential to each of the plurality of ribbons 72 according to the signal from the first controller 10, for example.

In the first embodiment, for example, regarding each of the plurality of ribbons 72, the first controller 10 adjusts the potential difference to be applied between the reflection part 72r and the reference electrode 71e, and can thereby deflect the ribbon 72 using the electrostatic force between the reflection part 72r and the reference electrode 71e and control displacement of the reflection part 72r with respect to the base part 71.

For example, a fixed reference first potential, such as from 0 volts (V) to -12 V, is applied to the reference electrode 71e, and a second potential, which is equal to or higher than the first potential, is applied to each of the plurality of ribbons 72. The second potential is set such that a difference (potential difference) between the second potential and the first potential becomes a desired potential difference within a predetermined range, such as from 0 V to 25 V, for example. For example, the second potential is a variable potential. The second potentials different from each other may be applied to the plurality of ribbons 72, for example. For example, this can freely make a difference in the displacement amount of the reflection part 72r among the plurality of ribbons 72. When the potential difference applied between the ribbon 72 and the reference electrode 71e reaches nearly zero after the ribbon 72 is deflected using the electrostatic force according to the potential difference applied between the ribbon 72 and the reference electrode 71e, the ribbon 72 returns to the undeflected reference state because of the elastic force of the ribbon 72. At this time, the displacement amount of the reflection part 72r returns to zero.

FIG. 5 illustrates an example of a first state in which the displacement amounts of the plurality of reflection parts 72r in the plurality of ribbons 72 are equally zero. In this case, the light reflecting surfaces of the plurality of reflection parts 72r are located along the grating surface P0, and the grating light valve as the spatial phase modulating element 7 functions as a mirror. The reference optical path Ln0 is an optical path along the normal line to the light reflecting surfaces of the reflection parts 72r, for example. In this case, the reference optical path Ln0 is an optical path along the normal line to the grating surface P0 of the grating light valve as the spatial phase modulating element 7. Here, the grating surface P0 of the grating light valve is a surface along the XY plane. The normal line to the grating surface P0 is an imaginary straight line extending along the Z direction.

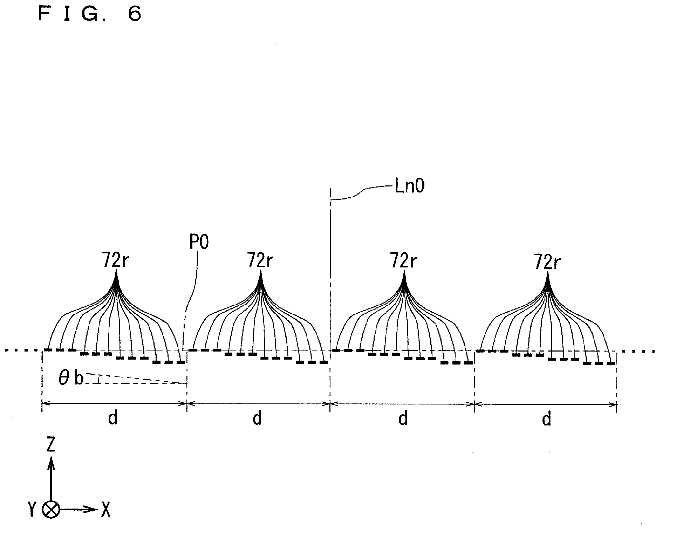

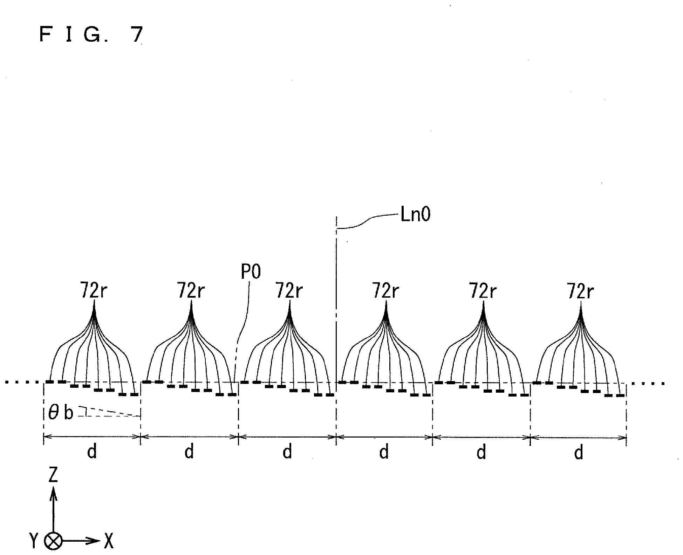

FIG. 6 illustrates an example of a second state in which the displacement amounts of the reflection parts 72r periodically change in the X direction, and the grating light valve as the spatial phase modulating element 7 functions as a blazed diffraction grating. FIG. 7 illustrates an example of a third state in which the displacement amounts of the reflection parts 72r periodically change in the X direction, and the grating light valve as the spatial phase modulating element 7 functions as a blazed diffraction grating. In each of FIG. 6 and FIG. 7, for the sake of convenience, a pitch (also referred to as a grating pitch) d of the grating being a period of displace and an angle (also referred to as a blaze angle) θb formed by a sawtooth-shaped inclined surface with respect to the grating surface P0 in the blazed diffraction grating are provided.

The grating pitch d and the blaze angle θb are different between the second state illustrated in FIG. 6 and the third state illustrated in FIG. 7. For example, when deflection amounts of the plurality of ribbons 72 are controlled by control on the second potential to be applied to each of the plurality of ribbons 72, the grating light valve as the spatial phase modulating element 7 may function as the blazed diffraction grating having a variable grating pitch d and blaze angle θb.

In the first embodiment, for example, the spectroscopic element 6 is disposed to emit light at different angles according to wavelengths in the X direction as the second direction in which the plurality of ribbons 72 as the plurality of grating elements are arrayed. Further, the spectroscopic element 6 is disposed such that the light emitted in a separated manner is radiated to the plurality of ribbons 72 as the plurality of grating elements. For example, the light emitted from the spectroscopic element 6 is radiated to a center portion of each of the plurality of ribbons 72 as the plurality of grating elements in the Y direction as the first direction. In other words, the light emitted from the spectroscopic element 6 is radiated to the plurality of reflection parts 72r constituting the plurality of ribbons 72 as the plurality of grating elements. Here, the light emitted from the spectroscopic element 6 is radiated to a linear or band-like region along substantially the center of the plurality of ribbons 72 as the plurality of grating elements in the Y direction as the first direction. In this case, light having different wavelengths in the X direction is radiated to the light reflecting surfaces of the plurality of reflection parts 72r. For example, an aspect is considered that the wavelengths of the light are shorter in the +X direction regarding the light emitted from the spectroscopic element 6 and radiated to the light reflecting surfaces of the plurality of reflection parts 72r.

Here, for example, the grating light valve as the spatial phase modulating element 7 can relatively displace at least a part of the ribbons 72 out of the plurality of ribbons 72 as the plurality of grating elements with respect to the base part 71. Further, for example, the grating light valve as the spatial phase modulating element 7 can perform phase modulation on the light separated by the spectroscopic element 6, and emit diffracted light toward the spectroscopic element 6 along an optical path (also referred to as an incident optical path) Li of incident light from the spectroscopic element 6 regarding a part of the wavelengths within the predetermined wavelength range of the light separated by the spectroscopic element 6. Consequently, the grating light valve as the spatial phase modulating element 7 can selectively send light having a part of the wavelengths (also referred to as selected wavelengths) out of the light separated by the spectroscopic element 6 back to the spectroscopic element 6.

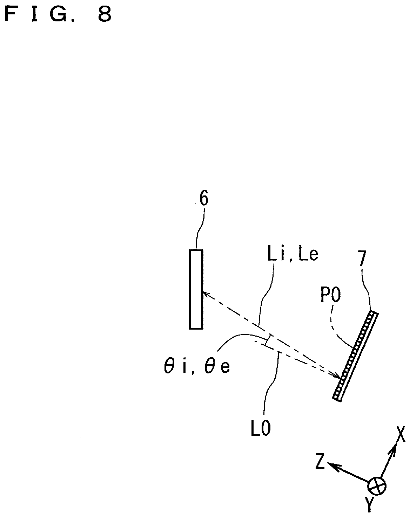

FIG. 8 to FIG. 10 are each a diagram schematically illustrating an example of a relationship between the optical path (incident optical path) Li of the incident light and an optical path (also referred to as an emission optical path) Le of diffracted light as emission light in the grating light valve.

When functioning as the blazed diffraction grating, the grating light valve as the spatial phase modulating element 7 can emit diffracted light at an angle according to the grating pitch d, depending on radiation of the incident light, for example. Further, for example, when the grating light valve as the spatial phase modulating element 7 functions as the blazed diffraction grating and is set to the so-called Littrow configuration, regarding the light of a desired wavelength, an angle (also referred to as an angle of incidence) θi formed by a normal line L0 to the grating surface P0 and the optical path (incident optical path) Li of the incident light and an angle (also referred to as an angle of diffraction) θe formed by the normal line L0 to the grating surface P0 and the optical path (emission optical path) Le of the diffracted light are equal to each other. In the Littrow configuration, for example, as depth (= d × tan θb) of the sawtooth-like pattern of the blazed diffraction grating is closer to a half of the desired wavelength, diffraction efficiency may be increased. In this case, for example, the angle of incidence θi, the angle of diffraction θe, and the blaze angle θb are equal to each other.

Here, for example, whether the blaze angle θb is positive or negative can be defined in such a manner that the blaze angle θb is a negative angle when the sawtooth-shaped inclined surface is, in the +X direction, inclined toward the -Z direction and the blaze angle θb is a positive angle when the sawtooth-shaped inclined surface is, in the -X direction, inclined toward the -Z direction. In this case, in plan view in the +Y direction, whether the angle of incidence θi and the angle of diffraction θe are positive or negative can be defined in such a manner that the angle of incidence θi and the angle of diffraction θe are negative angles when the incident optical path Li and the emission optical path Le are inclined counterclockwise to form acute angles with respect to the normal line L0 and the angle of incidence θi and the angle of diffraction θe are positive angles when the incident optical path Li and the emission optical path Le are inclined clockwise to form acute angles with respect to the normal line L0.

For example, in accordance with control of the first controller 10, the grating light valve as the spatial phase modulating element 7 relatively displaces at least a part of the reflection parts 72r out of the plurality of reflection parts 72r with respect to the base part 71, and may thereby be set to the Littrow configuration for a part of the wavelengths (selected wavelengths) within the predetermined wavelength range of the light separated by the spectroscopic element 6. In this case, the grating light valve as the spatial phase modulating element 7 can emit diffracted light toward the spectroscopic element 6 along the incident optical path Li of the incident light from the spectroscopic element 6 regarding the selected wavelengths. In other words, regarding light having the selected wavelengths, the angle (angle of incidence) θi formed by the normal line L0 to the grating surface P0 and the optical path (incident optical path) Li of the incident light and the angle (angle of diffraction) θe formed by the normal line L0 to the grating surface P0 and the optical path (emission optical path) Le of the diffracted light are equal to each other. Consequently, the grating light valve as the spatial phase modulating element 7 can selectively send light having the part of the wavelengths (selected wavelengths) out of the light separated by the spectroscopic element 6 back to the spectroscopic element 6. Further, the diffracted light having the selected wavelengths emitted from the spatial phase modulating element 7 generates light having the part of the wavelengths (selected wavelengths) within the predetermined wavelength range of the light separated by the spectroscopic element 6 in the spectroscopic element 6.

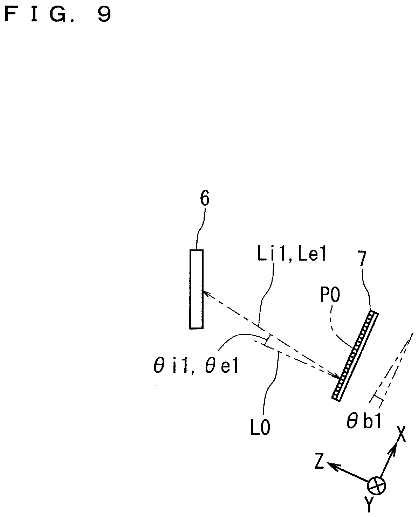

Here, for example, in accordance with control of the first controller 10, the grating light valve as the spatial phase modulating element 7 relatively displaces at least a part of the reflection parts 72r out of the plurality of reflection parts 72r with respect to the base part 71, and may thereby be set to the Littrow configuration for a first wavelength λ1 as the part of the wavelengths (selected wavelengths) within the predetermined wavelength range of the light separated by the spectroscopic element 6. Here, for example, as illustrated in FIG. 9, in the grating light valve as the spatial phase modulating element 7, a blaze angle (also referred to as a first blaze angle) θb1 corresponding to an angle (also referred to as a first angle of incidence) θi1 formed by an optical path (also referred to as a first incident optical path) Li1 of the first wavelength λ1 radiated from the spectroscopic element 6 toward the spatial phase modulating element 7 and the normal line L0 to the grating surface P0 is set. In this case, the grating light valve as the spatial phase modulating element 7 emits diffracted light having the first wavelength λ1 toward the spectroscopic element 6 along the incident optical path (first incident optical path) Li1 of the incident light having the first wavelength λ1 from the spectroscopic element 6. In other words, regarding light having the selected wavelengths, the angle (first angle of incidence) θi1 formed by the normal line L0 to the grating surface P0 and the optical path (first incident optical path) Li1 of the incident light having the first wavelength λ1 and an angle (also referred to as a first angle of diffraction) θe1 formed by the normal line L0 to the grating surface P0 and an optical path (also referred to as a first emission optical path) Le1 of the diffracted light having the first wavelength λ1 are equal to each other. Consequently, the grating light valve as the spatial phase modulating element 7 can selectively send light having the first wavelength λ1 as the light having the part of the wavelengths (selected wavelengths) out of the light separated by the spectroscopic element 6 back to the spectroscopic element 6. Further, the diffracted light having the first wavelength λ1 emitted from the spatial phase modulating element 7 generates light having the first wavelength λ1 as the part of the wavelengths (selected wavelengths) within the predetermined wavelength range of the light separated by the spectroscopic element 6 in the spectroscopic element 6.

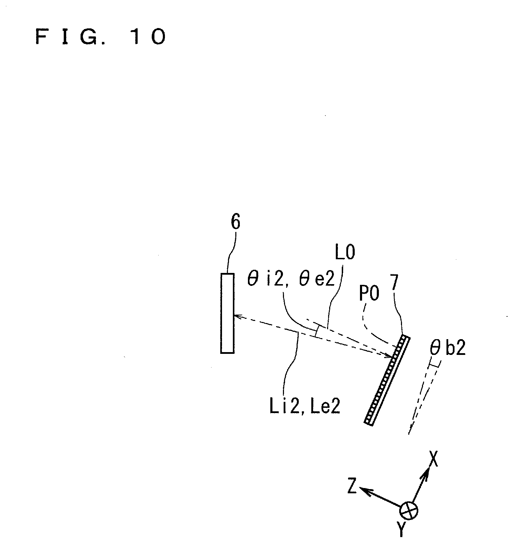

Further, here, for example, in accordance with control of the first controller 10, the grating light valve as the spatial phase modulating element 7 relatively displaces at least a part of the reflection parts 72r out of the plurality of reflection parts 72r with respect to the base part 71, and may thereby be set to the Littrow configuration for a second wavelength λ2 as the part of the wavelengths (selected wavelengths) within the predetermined wavelength range of the light separated by the spectroscopic element 6. The second wavelength λ2 is different from the first wavelength λ1. Here, for example, as illustrated in FIG. 10, in the grating light valve as the spatial phase modulating element 7, a blaze angle (also referred to as a second blaze angle) θb2 corresponding to an angle (also referred to as a second angle of incidence) θi2 formed by an optical path (also referred to as a second incident optical path) Li2 of the second wavelength λ2 radiated from the spectroscopic element 6 toward the spatial phase modulating element 7 and the normal line L0 to the grating surface P0 is set. In this case, the grating light valve as the spatial phase modulating element 7 emits diffracted light having the second wavelength λ2 toward the spectroscopic element 6 along the incident optical path (second incident optical path) Li2 of the incident light having the second wavelength λ2 from the spectroscopic element 6. In other words, regarding light having the selected wavelengths, the angle (second angle of incidence) θi2 formed by the normal line L0 to the grating surface P0 and the optical path (second incident optical path) Li2 of the incident light having the second wavelength λ2 and an angle (also referred to as a second angle of diffraction) θe2 formed by the normal line L0 to the grating surface P0 and an optical path (also referred to as a second emission optical path) Le2 of the diffracted light having the second wavelength λ2 are equal to each other. Consequently, the grating light valve as the spatial phase modulating element 7 can selectively send light having the second wavelength λ2 as the light having the part of the wavelengths (selected wavelengths) out of the light separated by the spectroscopic element 6 back to the spectroscopic element 6. Further, the diffracted light having the second wavelength λ2 emitted from the spatial phase modulating element 7 generates light having the second wavelength λ2 as the part of the wavelengths (selected wavelengths) within the predetermined wavelength range of the light separated by the spectroscopic element 6 in the spectroscopic element 6.

### <<Second Light Guide Part 8>>

The second light guide part 8 includes a first light output part 84 and a light guide portion 86, for example. In the example of FIG. 1, the second light guide part 8 includes an optical fiber 81 as a light transmission part, a collimator lens 82 being an optical lens, and an optical fiber 83 as a light transmission part. For example, light guided to the second light guide part 8 by the optical path change optical system 3 passes through the optical fiber 81, the collimator lens 82, and the optical fiber 83 in the mentioned order and then enters the first light output part 84.

The first light output part 84 outputs a part of light out of the light guided to the second light guide part 8 by the optical path change optical system 3 to the outside of the second light guide part 8 as output light. As the first light output part 84, an optical fiber coupler (also referred to as a coupler) is used, for example. For example, the coupler outputs a part of light that has entered the coupler to the outside of the second light guide part 8 via an optical fiber 85 being a light transmission part, and guides the rest of the light out of the light that has entered the coupler to the light guide portion 86. Here, for example, regarding the light that has entered the coupler, quantity of light of the rest of the light output to the light guide portion 86 is set to be several times to several tens of times as large as quantity of light of the output light output to the outside of the second light guide part 8 via the optical fiber 85. From another point of view, for example, regarding the light that has entered the coupler, the ratio between the quantity of light of the output light output to the outside of the second light guide part 8 via the optical fiber 85 and the quantity of light of the rest of the light output to the light guide portion 86 is set to "5 to 20":"95 to 80", for example. For example, the ratio between the quantity of light of the output light and the quantity of light of the rest of the light is set to 10:90 or the like.

The light guide portion 86 guides the rest of the light out of the light guided to the second light guide part 8 by the optical path change optical system 3 except the part of light (output light) output to the outside of the second light guide part 8 by the first light output part 84 toward the optical amplifier 1. Consequently, for example, the light that has entered the optical amplifier 1 is amplified by the optical amplifier 1, and is subsequently released toward the spectroscopic element 6. In other words, for example, the light having the part of the wavelengths (selected wavelengths) within the predetermined wavelength range generated in the spectroscopic element 6 according to the diffracted light emitted from the spatial phase modulating element 7 is amplified by the optical amplifier 1, and is subsequently released toward the spectroscopic element 6.

In the example of FIG. 1, the light guide portion 86 includes an optical fiber 861 as a light transmission part and a collimator lens 862 being an optical lens. In this case, for example, light guided from the first light output part 84 to the light guide portion 86 passes through the optical fiber 861 and the collimator lens 862 in the mentioned order and then enters another end surface (also referred to as a second end surface) E2 that is different from the first end surface E1 of the optical amplifier 1. Consequently, for example, the light that has entered the second end surface E2 of the optical amplifier 1 is amplified by the optical amplifier 1, and is subsequently released toward the spectroscopic element 6.

In the light source apparatus 100, the light released from the optical amplifier 1 may pass through a path (also referred to as an amplification path), in which the light passes through the spectroscopic element 6, the spatial phase modulating element 7, the spectroscopic element 6, and the optical amplifier 1 in the mentioned order, a plurality of times. Consequently, for example, according to radiation of light having intensity in the predetermined wavelength range from the optical amplifier 1, light having a part of wavelengths (selected wavelengths) subjected to a plurality of times of amplification by the optical amplifier 1 is output. As a result, for example, light having high intensity in a narrow wavelength range may be output from the light source apparatus 100.

### <<First Controller 10»

The first controller 10 controls operation of the spatial phase modulating element 7. Specifically, the first controller 10 controls displacement of the plurality of ribbons 72 (specifically, the plurality of reflection parts 72r) as the plurality of grating elements with respect to the base part 71 in the spatial phase modulating element 7. Here, for example, by the grating light valve as the spatial phase modulating element 7 changing a pattern of displacement of the plurality of ribbons 72 (specifically, the plurality of reflection parts 72r) as the plurality of grating elements with respect to the base part 71, the light having the part of the wavelengths (selected wavelengths) to be selectively sent back to the spectroscopic element 6 out of the light in the predetermined wavelength range separated by the spectroscopic element 6 can be quickly changed. As a result, for example, the wavelengths of the output light output from the light source apparatus 100 after a plurality of times of amplification can be quickly switched. Therefore, for example, the wavelengths of the light emitted by the light source apparatus 100 can be quickly changed.

In addition, for example, with each of the plurality of ribbons 72 (specifically, the plurality of reflection parts 72r) as the plurality of grating elements being fine, the displacement amounts of the plurality of ribbons 72 (specifically, the plurality of reflection parts 72r) as the plurality of grating elements can be accurately controlled. Consequently, for example, the wavelengths of the light emitted by the light source apparatus 100 can be accurately changed.

The first controller 10 includes a processor such as a central processing unit (CPU), a memory, and a storage, a field programmable gate array (FPGA), or the like, for example. As the storage, a non-volatile storage medium or the like that stores programs that can be executed by the CPU or the like is used, for example. The first controller 10 controls operation of the spatial phase modulating element 7, according to a signal, information, or the like from the control apparatus 200 outside of the light source apparatus 100, for example. The signal or the information input from the control apparatus 200 to the first controller 10 includes a signal or information indicating the pattern of displacement of the plurality of ribbons 72 (specifically, the plurality of reflection parts 72r) as the plurality of grating elements with respect to the base part 71 in the spatial phase modulating element 7, for example.

As the control apparatus 200, various types of computers or the like, such as a personal computer including the CPU, the storage, and the like, is used, for example. The control apparatus 200 generates the information indicating the pattern of displacement of the plurality of ribbons 72 (specifically, the plurality of reflection parts 72r) as the plurality of grating elements with respect to the base part 71 in the spatial phase modulating element 7 according to a surface shape of the blazed diffraction grating corresponding to the light having a desired wavelength (selected wavelength) to be output from the light source apparatus 100, for example. Here, the surface shape of the blazed diffraction grating corresponding to the light having a desired wavelength to be output from the light source apparatus 100 may be obtained through calculation or simulation based on relative positions and an orientation relationship between the spectroscopic element 6 and the spatial phase modulating element 7, information on spectral characteristic in the spectroscopic element 6, and the like, an experiment using the light source apparatus 100, or the like, for example. Elements that define the surface shape of the blazed diffraction grating include the blaze angle θb, the grating pitch d, and the like, for example.

The first controller 10 can change the pattern of displacement of the plurality of ribbons 72 (specifically, the plurality of reflection parts 72r) as the plurality of grating elements with respect to the base part 71 from a first pattern to a second pattern, using the grating light valve as the spatial phase modulating element 7, for example.

Here, for example, when the pattern of displacement of the plurality of ribbons 72 (specifically, the plurality of reflection parts 72r) as the plurality of grating elements with respect to the base part 71 is set to the first pattern, the grating light valve as the spatial phase modulating element 7 functions as the blazed diffraction grating having the blaze angle (first blaze angle) θb1 corresponding to the angle (first angle of incidence) θi1 formed by optical path (first incident optical path) Li1 of the incident light having the first wavelength λ1 radiated from the spectroscopic element 6 toward the spatial phase modulating element 7 and the normal line L0 to the grating surface P0. Further, for example, when the pattern of displacement of the plurality of ribbons 72 (specifically, the plurality of reflection parts 72r) as the plurality of grating elements with respect to the base part 71 is set to the second pattern, the grating light valve as the spatial phase modulating element 7 functions as the blazed diffraction grating having the blaze angle (second blaze angle) θb2 corresponding to the angle (second angle of incidence) θi2 formed by the optical path (second incident optical path) Li2 of the incident light having the second wavelength λ2 radiated from the spectroscopic element 6 toward the spatial phase modulating element 7 and the normal line L0 to the grating surface P0.

In this case, for example, when the first controller 10 changes the pattern of displacement of the plurality of ribbons 72 (specifically, the plurality of reflection parts 72r) as the plurality of grating elements with respect to the base part 71 from the first pattern to the second pattern, a state in which the part of the wavelengths (selected wavelengths) within the predetermined wavelength range of the light separated by the spectroscopic element 6 includes the first wavelength λ1 is switched to a state in which the part of the wavelengths (selected wavelengths) within the predetermined wavelength range of the light separated by the spectroscopic element 6 includes the second wavelength λ2. Thus, for example, the wavelengths of the output light output from the light source apparatus 100 can be randomly changed. As a result, for example, the wavelengths of the light emitted by the light source apparatus 100 can be quickly changed.

Further, the first controller 10 may change the pattern of displacement of the plurality of ribbons 72 (specifically, the plurality of reflection parts 72r) as the plurality of grating elements with respect to the base part 71 from the first pattern to a third pattern, using the grating light valve as the spatial phase modulating element 7, for example. Here, for example, when the pattern of displacement of the plurality of ribbons 72 (specifically, the plurality of reflection parts 72r) as the plurality of grating elements with respect to the base part 71 is set to the third pattern, regarding the light having the third wavelength λ3 within the predetermined wavelength range of the light separated by the spectroscopic element 6, the grating light valve as the spatial phase modulating element 7 emits diffracted light toward the spectroscopic element 6 along the incident optical path Li of the incident light from the spectroscopic element 6. In this case, for example, when the first controller 10 changes the pattern of displacement of the plurality of ribbons 72 (specifically, the plurality of reflection parts 72r) as the plurality of grating elements with respect to the base part 71 from the first pattern to the third pattern, the state in which the part of the wavelengths (selected wavelengths) within the predetermined wavelength range of the light separated by the spectroscopic element 6 includes the first wavelength λ1 is switched to a state in which the part of the wavelengths (selected wavelengths) within the predetermined wavelength range of the light separated by the spectroscopic element 6 includes the third wavelength λ3.

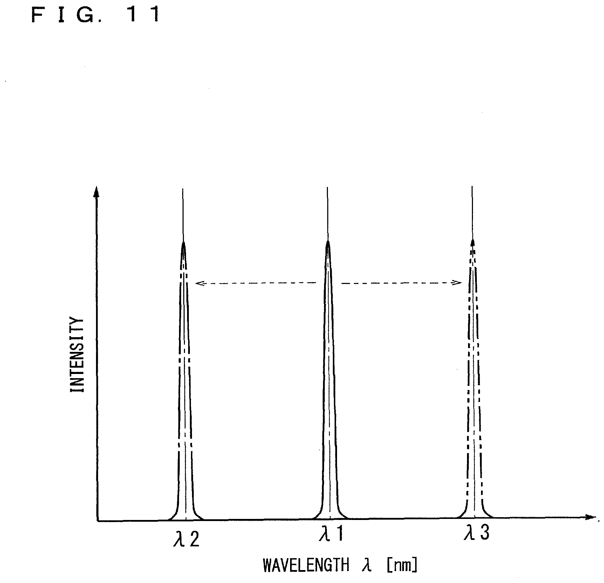

FIG. 11 is a graph schematically showing an example of switching of the wavelengths (selected wavelengths) of the output light output from the light source apparatus 100. In FIG. 11, an example of a spectrum of the output light when the wavelength of the output light output from the light source apparatus 100 is the first wavelength λ1 is schematically indicated by a curved line shown in a solid line, and an example of a spectrum of the output light when the wavelength of the output light output from the light source apparatus 100 is the second wavelength λ2 is schematically indicated by a curved line shown in a one-dot chain line. Further, in FIG. 11, an example of a spectrum of the output light when the wavelength of the output light output from the light source apparatus 100 is the third wavelength λ3 is schematically indicated by a curved line shown in a two-dot chain line.

As shown in FIG. 11, for example, an aspect is considered that the wavelengths of the output light output from the light source apparatus 100 are quickly switched from the first wavelength λ1 to the second wavelength λ2 that is apart from the first wavelength λ1 and is smaller than the first wavelength λ1. Further, for example, an aspect is considered that the wavelengths of the output light output from the light source apparatus 100 are quickly switched from the first wavelength λ1 to the third wavelength λ3 that is apart from the first wavelength λ1 and is larger than the first wavelength λ1. Here, the second wavelength λ2 and the third wavelength λ3 may be switched.

In this manner, in the light source apparatus 100, for example, as described above, by selectively sending the light having the part of the wavelengths (selected wavelengths) out of the light separated by the spectroscopic element 6 back to the spectroscopic element 6 using the grating light valve as the spatial phase modulating element 7, the wavelengths of the output light output from the light source apparatus 100 can be randomly increased and decreased.

Incidentally, for example, in the external cavity wavelength swept light source using the oscillating mirror of the MEMS described in the background art, by oscillating an oscillating mirror larger than the ribbon 72 (specifically, the reflection part 72r) as the grating element in the light source apparatus 100, the wavelengths of the output light are swept. Thus, for example, there is a limitation that the oscillating mirror can only be oscillated within a range of a certain angle or larger. Thus, for example, it is not easy to sweep the wavelengths of the output light within a range of narrow wavelengths, such as less than 10 nm or the like. In contrast, in the light source apparatus 100 according to the first embodiment, by controlling the displacement amounts of the plurality of ribbons 72 (specifically, the plurality of reflection parts 72r) as the plurality of grating elements finer than the oscillating mirror of the MEMS, the wavelengths of the output light can be swept with the wavelengths of the output light being within a range of narrow wavelengths such as from 1 nm to less than 10 nm or the like, for example.

### <<Second Controller 20»

The second controller 20 includes a processor such as a central processing unit (CPU), a memory, and a storage, a field programmable gate array (FPGA), or the like, for example. As the storage, a non-volatile storage medium or the like that stores programs that can be executed by the CPU or the like is used, for example. The second controller 20 may control the optical amplifier 1 according to a signal from the control apparatus 200, for example.

### <1-2. Summary of First Embodiment>

As described above, in the light source apparatus 100 according to the first embodiment, for example, the pattern of displacement of the plurality of ribbons 72 (specifically, the plurality of reflection parts 72r) as the plurality of grating elements with respect to the base part 71 can be changed by the grating light valve as the spatial phase modulating element 7. Consequently, for example, the light having the part of the wavelengths (selected wavelengths) to be selectively sent back to the spectroscopic element 6 out of the light in the predetermined wavelength range separated by the spectroscopic element 6 can be quickly changed. As a result, for example, the wavelengths of the output light output from the light source apparatus 100 can be quickly switched after a plurality of times of amplification. Therefore, for example, the wavelengths of the light emitted by the light source apparatus 100 can be quickly changed.

Further, in the light source apparatus 100 according to the first embodiment, for example, when the pattern of displacement of the plurality of ribbons 72 (specifically, the plurality of reflection parts 72r) as the plurality of grating elements with respect to the base part 71 is changed from the first pattern to the second pattern, the state in which the part of the wavelengths (selected wavelengths) within the predetermined wavelength range of the light separated by the spectroscopic element 6 includes the first wavelength λ1 is switched to the state in which the part of the wavelengths (selected wavelengths) within the predetermined wavelength range of the light separated by the spectroscopic element 6 includes the second wavelength λ2. Consequently, for example, the wavelengths of the output light output from the light source apparatus 100 can be randomly changed. As a result, for example, the wavelengths of the light emitted by the light source apparatus 100 can be quickly changed.

### <2. Modifications>

The present invention is not limited to the first embodiment described above, and various modifications, improvements, and the like can be made within the scope not departing from the gist of the present invention.

### <<First Modification>>

In the first embodiment described above, for example, the part of the wavelengths (selected wavelengths) of the light to be selectively sent back to the spectroscopic element 6 by the grating light valve as the spatial phase modulating element 7 within the predetermined wavelength range of the light separated by the spectroscopic element 6 may include a plurality of wavelengths being different and apart from each other. Here, for example, when the first controller 10 sets the pattern of displacement of the plurality of ribbons 72 (specifically, the plurality of reflection parts 72r) as the plurality of grating elements with respect to the base part 71 to the first pattern using the grating light valve as the spatial phase modulating element, the first controller 10 may selectively send light having a plurality of wavelengths being different and apart from each other within the predetermined wavelength range of the light separated by the spectroscopic element 6 back to the spectroscopic element 6 as light having the selected wavelengths. In this case, for example, the wavelengths of the light selectively sent back to the spectroscopic element 6 out of the light in the predetermined wavelength range separated by the spectroscopic element 6 include the plurality of wavelengths being different and apart from each other, and therefore the light having the plurality of wavelengths being different and apart from each other can be simultaneously output from the light source apparatus 100.

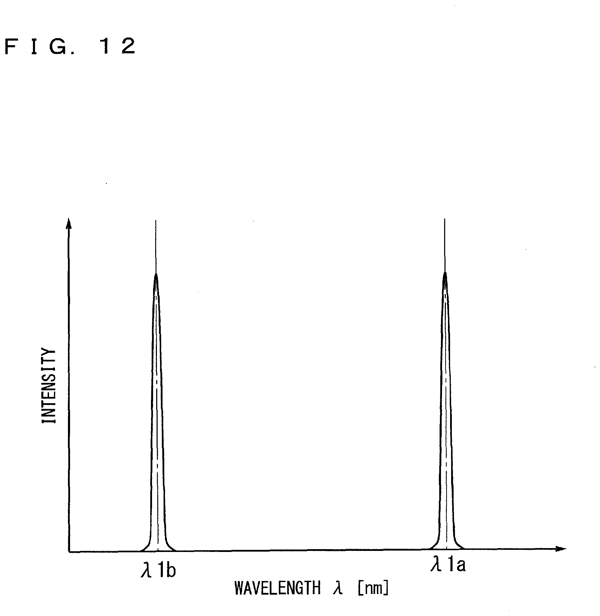

FIG. 12 is a graph schematically showing an example of a relationship between the wavelengths and the intensity regarding the output light having a plurality of wavelengths output from the light source apparatus 100. As shown in FIG. 12, an aspect is considered that the plurality of wavelengths being different and apart from each other include a first-A wavelength λ1a and a first-B wavelength λ1b that are apart from each other and are in different relationships. Here, for example, the spectrum of the entire output light includes a peak (also referred to as a first-A peak) in the first-A wavelength λ1a and a peak (also referred to as a first-B peak) in the first-B wavelength λ1b.

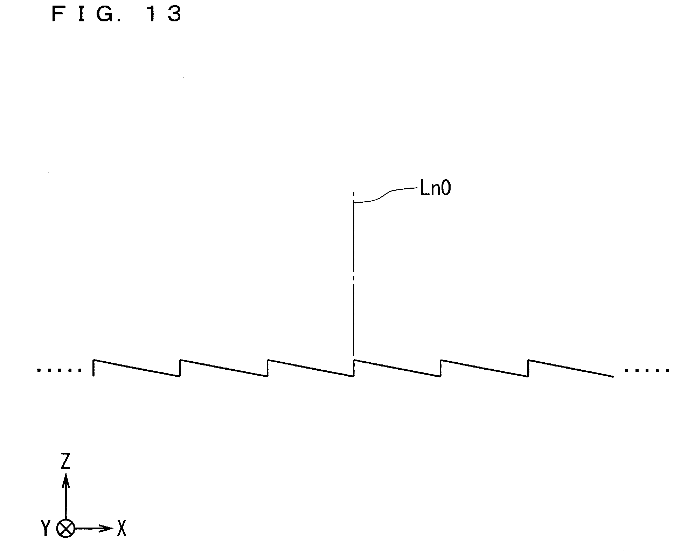

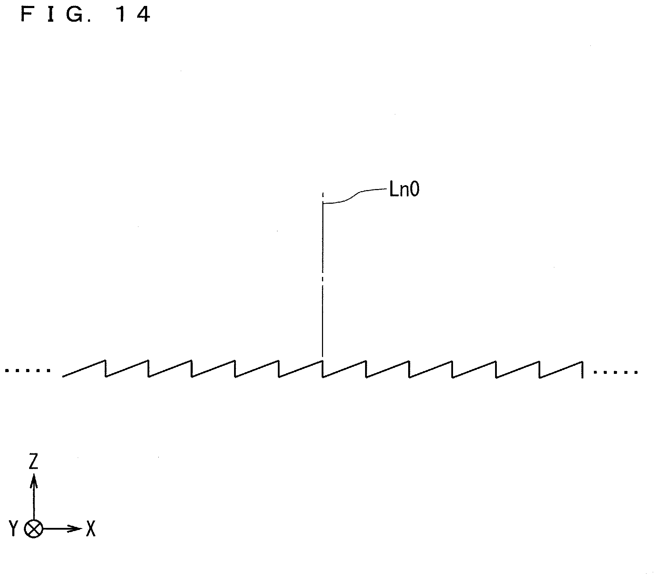

FIG. 13 is a cross-sectional diagram schematically illustrating an example of a first-A pattern relating to the surface shape of the blazed diffraction grating functionally implemented in the grating light valve as the spatial phase modulating element 7. FIG. 14 is a cross-sectional diagram schematically illustrating an example of a first-B pattern relating to the surface shape of the blazed diffraction grating functionally implemented in the grating light valve as the spatial phase modulating element 7.

Here, for example, when the pattern of displacement of the plurality of ribbons 72 (specifically, the plurality of reflection parts 72r) as the plurality of grating elements with respect to the base part 71 in the grating light valve as the spatial phase modulating element 7 is the pattern of displacement corresponding to the surface shape of the first-A pattern as illustrated in FIG. 13, the blazed diffraction grating functionally implemented in the grating light valve as the spatial phase modulating element 7 has the Littrow configuration for the first-A wavelength λ1a as the part of the wavelengths (selected wavelengths) within the predetermined wavelength range of the light separated by the spectroscopic element 6. Further, here, for example, when the pattern of displacement of the plurality of ribbons 72 (specifically, the plurality of reflection parts 72r) as the plurality of grating elements with respect to the base part 71 in the grating light valve as the spatial phase modulating element 7 is the pattern of displacement corresponding to the surface shape of the first-B pattern as illustrated in FIG. 14, the blazed diffraction grating functionally implemented in the grating light valve as the spatial phase modulating element 7 has the Littrow configuration for the first-B wavelength λ1b as the part of the wavelengths (selected wavelengths) within the predetermined wavelength range of the light separated by the spectroscopic element 6.

In this case, for example, the control apparatus 200 may generate a pattern (also referred to as a combined pattern) of the surface shape based on the surface shape of the first-A pattern and the surface shape of the first-B pattern, and generate information indicating the pattern of displacement of the plurality of ribbons 72 (specifically, the plurality of reflection parts 72r) as the plurality of grating elements with respect to the base part 71 in the spatial phase modulating element 7 according to the surface shape of the combined pattern of the blazed diffraction grating. Here, for example, an aspect is considered that the control apparatus 200 generates the combined pattern by combining the surface shape of the first-A pattern and the surface shape of the first-B pattern using the so-called inverse Fourier transform method.

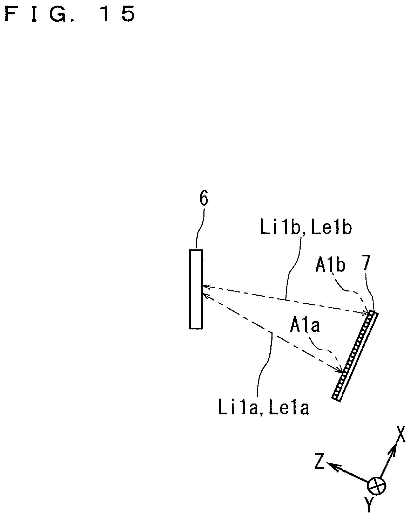

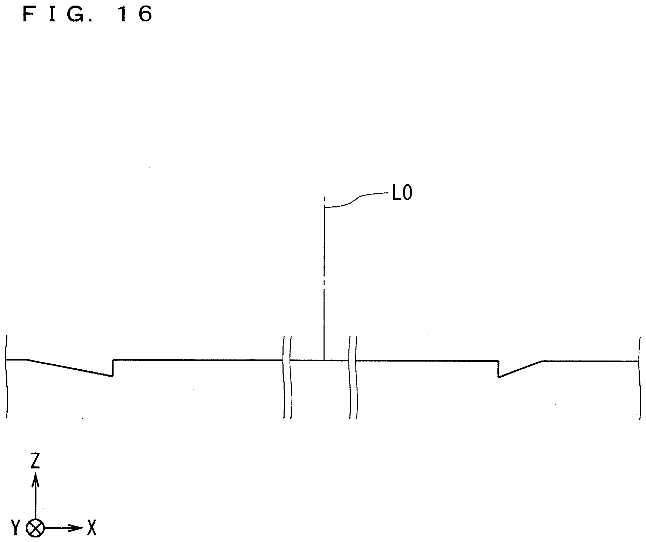

FIG. 15 is a diagram for illustrating an example of a method of generating the combined pattern for sending light having a plurality of wavelengths back to the spectroscopic element regarding the surface shape of the blazed diffraction grating functionally implemented in the grating light valve as the spatial phase modulating element 7. FIG. 16 is a cross-sectional diagram schematically illustrating an example of the combined pattern relating to the surface shape of the blazed diffraction grating functionally implemented in the grating light valve as the spatial phase modulating element 7.

Here, for example, as illustrated in FIG. 15 and FIG. 16, an aspect may be employed that the control apparatus 200 generates the combined pattern so that the grating light valve as the spatial phase modulating element 7 has the surface shape of the first-A pattern at a position corresponding to a region (also referred to as a first-A region ) A1a to which the light having the first-A wavelength λ1a is radiated, and the grating light valve as the spatial phase modulating element 7 has the surface shape of the first-B pattern at a position corresponding to a region (also referred to as a first-B region) A1b to which the light having the first-B wavelength λ1b is radiated.

Here, for example, when the first-A wavelength λ1a and the first-B wavelength λ1b are freely set, light having any plurality of wavelengths being different and apart from each other can be simultaneously output from the light source apparatus 100. As a result, for example, light having high intensity in each of a plurality of different narrow wavelength ranges can be output from the light source apparatus 100.

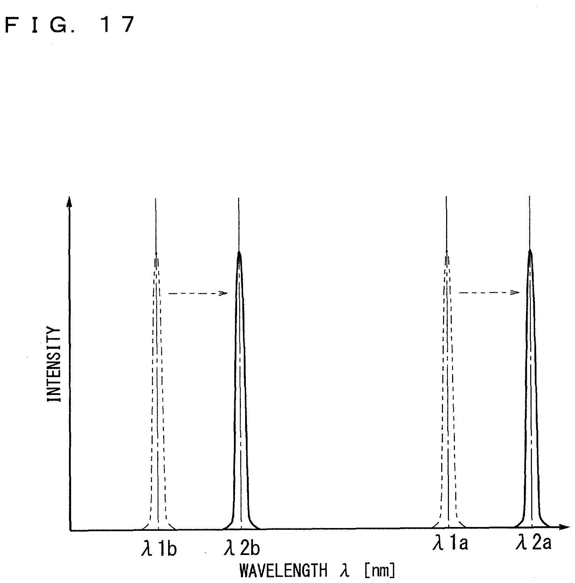

FIG. 17 is a graph schematically showing an example of switching of a plurality of wavelengths of the output light output from the light source apparatus 100. In FIG. 17, an example of a spectrum of the output light when the wavelengths of the output light output from the light source apparatus 100 are the first-A wavelength λ1a and the first-B wavelength λ1b as the plurality of wavelengths is schematically indicated by a curved line shown in a thin two-dot chain line, and an example of a spectrum of the output light when the wavelengths of the output light output from the light source apparatus 100 are the second-A wavelength λ2a and the second-B wavelength λ2b as the plurality of wavelengths being different and apart from each other is schematically indicated by a curved line shown in a solid line. When the wavelengths of the output light output from the light source apparatus 100 are the second-A wavelength λ2a and the second-B wavelength λ2b as the plurality of wavelengths being different and apart from each other, the spectrum of the entire output light includes a peak (also referred to as a second-A peak) in the second-A wavelength λ2a and a peak (also referred to as a second-B peak) in the second-B wavelength λ2b, for example.

Here, for example, the first controller 10 changes the pattern of displacement of the plurality of ribbons 72 (specifically, the plurality of reflection parts 72r) as the plurality of grating elements with respect to the base part 71 from the first pattern to the second pattern using the grating light valve as the spatial phase modulating element 7, and may thereby switch from a state in which the plurality of wavelengths as the part of the wavelengths (selected wavelengths) within the predetermined wavelength range of the light separated by the spectroscopic element 6 include the first-A wavelength λ1a and the first-B wavelength λ1b to a state in which the plurality of wavelengths as the part of the wavelengths (selected wavelengths) within the predetermined wavelength range of the light separated by the spectroscopic element 6 include the second-A wavelength λ2a and the second-B wavelength λ2b. In this case, for example, by changing the pattern of displacement of the plurality of ribbons 72 (specifically, the plurality of reflection parts 72r) as the plurality of grating elements of the grating light valve as the spatial phase modulating element 7 with respect to the base part 71 from the first pattern to the second pattern, the plurality of wavelengths of the light simultaneously output from the light source apparatus 100 can be randomly changed. As a result, for example, the plurality of wavelengths of the light simultaneously emitted by the light source apparatus 100 can be quickly changed.

As shown in FIG. 17, for example, an aspect is considered that two wavelengths of the output light output from the light source apparatus 100 can be quickly switched from the first-A wavelength λ1a and the first-B wavelength λ1b to the second-A wavelength λ2a apart from the first-A wavelength λ1a in a direction of increasing the wavelength and the second-B wavelength λ2b apart from the first-B wavelength λ1b in a direction of increasing the wavelength. Here, for example, the second-A wavelength λ2a may be smaller than the first-A wavelength λ1a, and the second-B wavelength λ2b may be smaller than the first-B wavelength λ1b.

Here, the light source apparatus 100 that can quickly transform a plurality of wavelengths of simultaneously emitted light can be applied to an apparatus or a system that performs long distance high-accuracy range measurement of the Dual beat method using a beat signal of two wavelengths in a range measurement technology in the frequency modulation continuous wave (FMCW) method, for example. In long distance high-accuracy range measurement of the Dual beat method, by simultaneously using light having two different wavelengths, a beat signal equivalent to a frequency difference between reference light and feedback light is detected through the use of interference between the feedback light from an object and the reference light with each ray of the reference light being swept to thereby obtain a frequency spectrum relating to the beat signal by fast Fourier transform (FFT) or the like, and thus a distance to the object is measured, for example.

### <<Second Modification>>

In the first embodiment and the modification described above, for example, a configuration may be employed that light may be released from the first end surface E1 of the optical amplifier 1, and light generated in the spectroscopic element 6 according to diffracted light emitted from the spatial phase modulating element 7 may be sent back to the first end surface E1 of the optical amplifier 1.

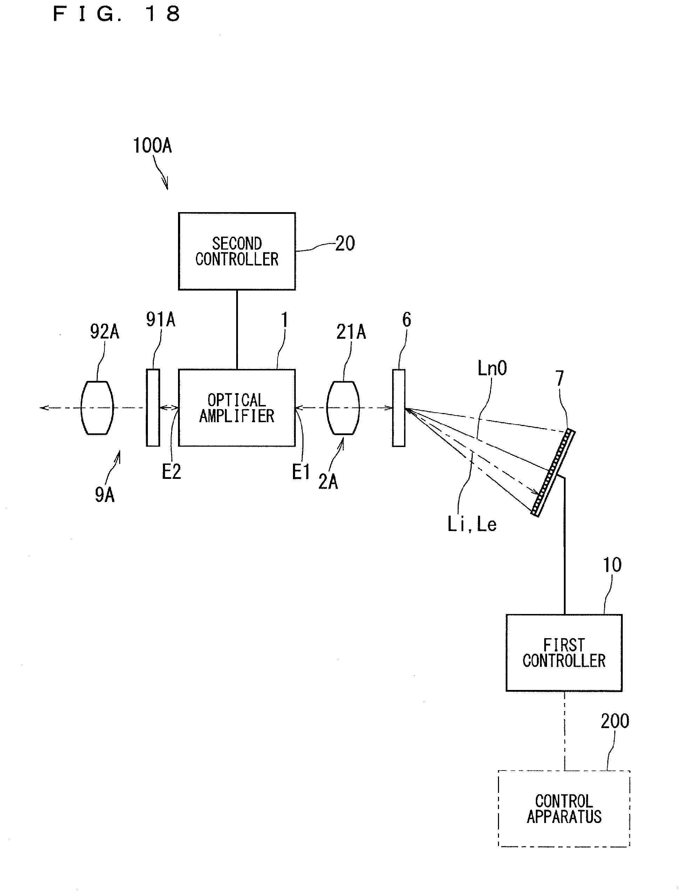

FIG. 18 is a diagram schematically illustrating a configuration of a light source apparatus 100A according to a modification. In FIG. 18, similarly to FIG. 1, a traveling direction of light is indicated by an arrow shown in a thin one-dot chain line.

The light source apparatus 100A, which is based on the light source apparatus 100 according to the first embodiment, includes a third light guide part 2A and a partially reflecting optical system 9A in place of the first light guide part 2, the optical path change optical system 3, the second light guide part 8, the optical fiber 4, and the collimator lens 5. In other words, the light source apparatus 100A includes the third light guide part 2A and the partially reflecting optical system 9A in addition to the optical amplifier 1, the spectroscopic element 6, the spatial phase modulating element 7, and the first controller 10. Further, the light source apparatus 100 includes the second controller 20, for example.

The third light guide part 2A guides light released from the first end surface E1 of the optical amplifier 1 toward the spectroscopic element 6, and guides light having a part of wavelengths (selected wavelengths) generated in the spectroscopic element 6 according to diffracted light emitted from the spatial phase modulating element 7 toward the first end surface E1 of the optical amplifier 1. As the third light guide part 2A, a collimator lens 21A or the like being an optical lens disposed between the optical amplifier 1 and the spectroscopic element 6 is used, for example.

The partially reflecting optical system 9A allows a part of light out of the light released from the second end surface E2 of the optical amplifier 1 to be transmitted therethrough and outputs the part of light as output light, and reflects the rest of the light except the part of light out of the light released from the second end surface E2 of the optical amplifier 1 toward the second end surface E2 of the optical amplifier 1. As the partially reflecting optical system 9A, a partially reflecting mirror 91A and a collimator lens 92A being an optical lens are used, for example. As the partially reflecting mirror 91A, a semi-transparent mirror, a one-way mirror, or the like is used, for example. The partially reflecting mirror 91A allows a part of the light released from the second end surface E2 of the optical amplifier 1 to be transmitted therethrough, and outputs the part of light to the outside of the partially reflecting optical system 9A via the collimator lens 92A as output light.

Here, quantity of light of the light (rest of the light) reflected toward the second end surface E2 of the optical amplifier 1 by the partially reflecting mirror 91A out of the light released from the second end surface E2 of the optical amplifier 1 is set to be several times to several tens of times as large as quantity of light of the light (part of the light) allowed to be transmitted through the partially reflecting mirror 91A out of the light released from the second end surface E2 of the optical amplifier 1. From another point of view, of the light radiated from the second end surface E2 of the optical amplifier 1 to the partially reflecting mirror 91A, the ratio between the quantity of light of the part of the light (also referred to as transmitted light) allowed to be transmitted through the partially reflecting mirror 91A and the quantity of light of the rest of the light (also referred to as reflected light) reflected by the partially reflecting mirror 91A is set to "5 to 20":"95 to 80", for example. For example, the ratio between the quantity of light of the transmitted light and the quantity of light of the reflected light in the partially reflecting mirror 91A is set to 10:90 or the like.

In the light source apparatus 100A having the configuration described above, the light released from the optical amplifier 1 may pass through a path (also referred to as a reciprocation path), in which the light passes through the third light guide part 2A, the spectroscopic element 6, the spatial phase modulating element 7, the spectroscopic element 6, the third light guide part 2A, the optical amplifier 1, the partially reflecting optical system 9A, and the optical amplifier 1 in the mentioned order, a plurality of times. In other words, the light released from the optical amplifier 1 reciprocates between the partially reflecting optical system 9A and the spatial phase modulating element 7, and is subjected to a plurality of times of amplification by the optical amplifier 1. Consequently, for example, according to radiation of light having intensity in the predetermined wavelength range from the optical amplifier 1, light having a part of wavelengths (selected wavelengths) subjected to a plurality of times of amplification by the optical amplifier 1 is output. As a result, for example, light having high intensity in a narrow wavelength range may be output from the light source apparatus 100A.

### <<Third Modification>>

In the first embodiment and each modification described above, for example, as the spatial phase modulating element 7, a planar light valve may be used instead of the grating light valve.

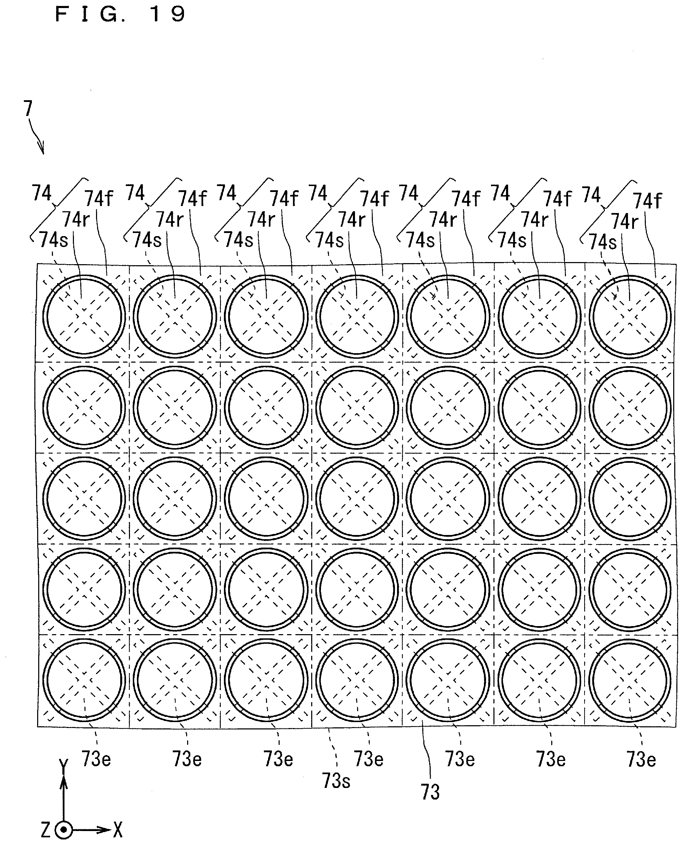

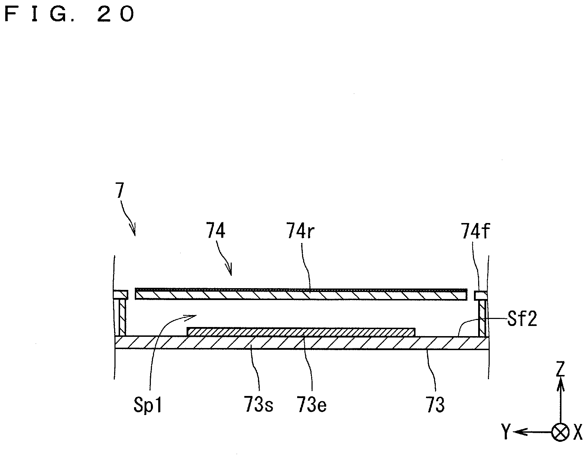

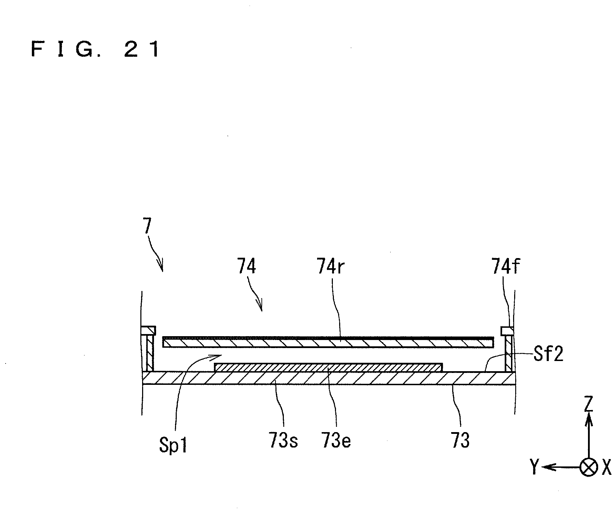

FIG. 19 is a plan view schematically illustrating an example of a configuration of the planar light valve. FIG. 19 illustrates a part of a configuration of the planar light valve. FIG. 20 and FIG. 21 are each a cross-sectional diagram schematically illustrating a configuration of a single reflective element 74 and a base part 73 in the planar light valve. In FIG. 19 to FIG. 21, a first direction along a main surface (also referred to as a second main surface) Sf2 of a substrate 73s constituting the planar light valve on the +Z direction side is the +Y direction, a second direction along the second main surface Sf2 and perpendicular to the +Y direction is the +X direction, and a third direction along the normal line to the second main surface Sf2 is the +Z direction. In FIG. 20 and FIG. 21, for the sake of convenience, illustration of a support part 74s to be described later is omitted.

The planar light valve as the spatial phase modulating element 7 includes a base part 73 and a plurality of reflective elements 74, for example.

The base part 73 includes the substrate 73s and an electrode (also referred to as a reference electrode) 73e, for example. As the substrate 73s, a plate-like substrate such as a silicon substrate is used, for example. The reference electrode 73e is located along the second main surface Sf2 of the substrate 73s. As the reference electrode 73e, a metal film formed on the second main surface Sf2 of the substrate 73s is used, for example. The reference electrode 73e may be an electrode provided for each reflective element 74, or may be a common electrode for the plurality of reflective elements 74, for example.

The plurality of reflective elements 74 are arrayed in a matrix shape. More specifically, the plurality of reflective elements 74 are arrayed on the second main surface Sf2 of the substrate 73s in a matrix shape. In the planar light valve, for example, M reflective elements 74 are disposed in the Y direction and N reflective elements 74 are disposed in the X direction. Here, M and N are natural numbers, and each of M and N is a numerical value from several hundreds to several thousands, for example.

Each of the plurality of reflective elements 74 includes a movable reflection part 74r and a support part 74s. Here, the plurality of movable reflection parts 74r in the plurality of reflective elements 74 function as the plurality of grating elements that reflect the light separated by the spectroscopic element 6. Further, in the examples of FIG. 19 to FIG. 21, each of the plurality of reflective elements 74 includes a fixed reflection part 74f.

As illustrated in FIG. 19 to FIG. 21, the fixed reflection part 74f is a planar member having a substantially rectangular shape being fixed to the substrate 73s, and has a substantially circular opening at the center. A surface (also referred to as an upper surface) of the fixed reflection part 74f facing the +Z direction includes a light reflecting surface (also referred to as a fixed light reflecting surface) that specularly reflects light.

The movable reflection part 74r includes a light reflecting surface (also referred to as a movable light reflecting surface) that specularly reflects light on an opposite side of the base part 73. The light reflecting surface is a surface in parallel to the XY plane. For example, the surface of each movable reflection part 74r has a configuration of being covered with a metal thin film, such as aluminum, that specularly reflects light. Consequently, for example, the surface of each movable reflection part 74r on the opposite side of the base part 73 has a function as the light reflecting surface. Here, for example, owing to the movable reflection part 74r including the light reflecting surface, each movable reflection part 74r can reflect the light separated by the spectroscopic element 6.

The support part 74s has flexibility, and supports each of a plurality of portions of the movable reflection part 74r and is connected to the base part 73. As the support part 74s, a fine structure configured with an amorphous silicon nitride film or the like is used, for example. The support part 74s is configured with a part of a structure having a cross shape (also referred to as a cross-shaped structure), for example. In this case, the cross-shaped structure includes a center portion that constitutes a part of a surface (also referred to as a back surface) of the movable reflection part 74r in the -Z direction and four end portions as the support part 74s provided to stretch over between the movable reflection part 74r and the base part 73. The surface of the cross-shaped structure has a configuration of being covered with a metal thin film, such as aluminum. The metal thin film has a function as an electrode (also referred to as a movable electrode). In other words, the movable reflection part 74r has a function as the movable electrode.

Here, the movable reflection part 74r faces the base part 73 across the space Sp1. Further, each movable reflection part 74r faces the reference electrode 73e of the base part 73 reference electrode 73e of the base part 73 across the space Sp1. In other words, the reference electrode 73e of the base part 73 faces each movable reflection part 74r. Further, the support part 74s supports the movable reflection part 74r without coming in contact with the reference electrode 73e, for example. Thus, for example, when the support part 74s is deflected, as illustrated in FIG. 20 and FIG. 21, the movable reflection part 74r may be displaced with respect to the base part 73.

Here, for example, when a potential difference is applied between the movable reflection part 74r having a function as the movable electrode and the reference electrode 73e, an electrostatic force that attracts the movable reflection part 74r to the reference electrode 73e is generated between the movable reflection part 74r and the reference electrode 73e. The electrostatic force deflects the support part 74s.

The planar light valve as the spatial phase modulating element 7 deflects the support part 74s using the electrostatic force according to a signal from the first controller 10, and thereby displaces the movable reflection part 74r by a displacement amount according to the signal, for example.

For example, regarding each of the plurality of reflective elements 74, the first controller 10 adjusts the potential difference to be applied between the movable reflection part 74r and the reference electrode 73e, and can thereby deflect the support part 74s using the electrostatic force between the movable reflection part 74r and the reference electrode 73e and control displacement of the movable reflection part 74r with respect to the base part 73. In other words, the first controller 10 can control displacement of the plurality of movable reflection parts 74r as the plurality of grating elements with respect to the base part 73. Note that, here, for example, when the potential difference applied between the movable reflection part 74r and the reference electrode 73e reaches nearly zero after the support part 74s is deflected using the electrostatic force according to the potential difference applied between the movable reflection part 74r and the reference electrode 73e, the support part 74s returns to the undeflected reference state because of the elastic force of the support part 74s. At this time, the displacement amount of the movable reflection part 74r returns to zero.

Here, the displacement amounts of the respective movable reflection parts 74r in the plurality of reflective elements 74 arrayed along the Y direction are controlled to be the same. In other words, regarding the plurality of reflective elements 74 arrayed in a matrix shape, the displacement amounts of the movable reflection parts 74r are controlled, with the plurality of reflective elements 74 forming a row arrayed along the Y direction being one unit. Thus, for example, the planar light valve may function as the blazed diffraction grating with the displacement amounts of the movable reflection parts 74r being periodically changed in the X direction in aspects similar to the second state and the third state illustrated in FIG. 6 and FIG. 7 in the grating light valve described above. Further, for example, when the deflection amounts of the plurality of support parts 74s are controlled by control or the like on the potential to be applied to the movable electrode of the plurality of movable reflection parts 74r, the planar light valve as the spatial phase modulating element 7 may function as the blazed diffraction grating having a variable grating pitch d and blaze angle θb.

Thus, for example, the planar light valve as the spatial phase modulating element 7 can relatively displace at least a part of the movable reflection parts 74r out of the plurality of movable reflection parts 74r as the plurality of grating elements with respect to the base part 73 and thereby perform phase modulation on the light separated by the spectroscopic element 6, and emit diffracted light toward the spectroscopic element 6 along the optical path (incident optical path) Li of the incident light from the spectroscopic element 6 regarding a part of the wavelengths within the predetermined wavelength range of the light separated by the spectroscopic element 6. Consequently, the planar light valve as the spatial phase modulating element 7 can selectively send light having a part of the wavelengths (also referred to as selected wavelengths) out of the light separated by the spectroscopic element 6 back to the spectroscopic element 6.

Accordingly, also when the planar light valve is used as the spatial phase modulating element 7, similarly to the first embodiment described above, by changing the pattern of displacement of the plurality of movable reflection parts 74r as the plurality of grating elements with respect to the base part 73, the light having the part of the wavelengths (selected wavelengths) to be selectively sent back to the spectroscopic element 6 out of the light in the predetermined wavelength range separated by the spectroscopic element 6 can be quickly changed. As a result, for example, the wavelengths of the output light output from the light source apparatuses 100 and 100A after a plurality of times of amplification can be quickly switched. Therefore, for example, the wavelengths of the light emitted by the light source apparatuses 100 and 100A can be quickly changed.

Here, for example, the shape of each of the plurality of movable reflection parts 74r is not limited to a disk-like shape, and upper and lower surfaces may have various plate-like shapes, such as a rectangular plate-like shape.

### <<Other Modifications>>

In the first embodiment and each modification described above, for example, the depth (= d × tan θb) of the sawtooth-like pattern of the blazed diffraction grating functionally implemented in the spatial phase modulating element 7 need not always be set to a half of the selected wavelengths. Here, for example, the depth (= d × tan θb) of the sawtooth-like pattern of the blazed diffraction grating functionally implemented in the spatial phase modulating element 7 may be set to a half of a specific wavelength within the predetermined wavelength range. As the specific wavelength, a wavelength at the center of the predetermined wavelength range or a wavelength around the center may be used, for example.

In the first embodiment and each modification described above, for example, the first controller 10 and the second controller 20 may be one controller.

In the first embodiment and each modification described above, for example, a part of functions of the first controller 10 and the second controller 20 may be assigned to an external apparatus of the light source apparatus 100. As the external apparatus, the control apparatus 200 or the like may be used, for example.

In the first embodiment and each modification described above, a portion where the optical fiber is provided may be replaced with a free space as appropriate, depending on disposition of elements in front and behind the portion on the optical path.

Note that it goes without saying that all or a part of the configurations in the first embodiment and various modifications described above can be combined as appropriate, unless there is an inconsistency.

### EXPLANATION OF REFERENCE SIGNS

- 1: Optical amplifier
- 10: First controller
- 100, 100A: Light source apparatus
- 2: First light guide part
- 20: Second controller
- 2A: Third light guide part
- 3: Optical path change optical system
- 6: Spectroscopic element
- 7: Spatial phase modulating element
- 71, 73: Base part
- 71e, 73e: Reference electrode
- 71s, 73s: Substrate
- 72: Ribbon
- 72c: Connection part
- 72r: Reflection part
- 74: Reflective element
- 74r: Movable reflection part
- 74s: Support part
- 8: Second light guide part
- 84: First light output part
- 86: Light guide portion
- 9A: Partially reflecting optical system
- E1: First end surface
- E2: Second end surface
- Li: Incident optical path
- Sp1: Space

## Claims

1. A light source apparatus comprising:
an optical amplifier configured to amplify and release light;
a spectroscopic element configured to separate the light released from the optical amplifier according to wavelengths;
a spatial phase modulating element including a base part and a plurality of grating elements configured to reflect the light separated by the spectroscopic element, the spatial phase modulating element being configured to relatively displace at least a part of grating elements out of the plurality of grating elements with respect to the base part and thereby perform phase modulation on the light separated by the spectroscopic element, and emit diffracted light toward the spectroscopic element along an incident optical path from the spectroscopic element regarding a part of the wavelengths within a wavelength range of the light separated by the spectroscopic element; and
a controller configured to control displacement of the plurality of grating elements with respect to the base part, wherein
the diffracted light emitted from the spatial phase modulating element generates the light having the part of the wavelengths in the spectroscopic element, and the light having the part of the wavelengths is amplified by the optical amplifier and is subsequently released toward the spectroscopic element, and
the light having the part of the wavelengths subjected to a plurality of times of amplification by the optical amplifier is output.

2. The light source apparatus according to claim 1, wherein
the optical amplifier includes a semiconductor optical amplifier, a booster optical amplifier, or a semiconductor laser.

3. The light source apparatus according to claim 1 or 2, wherein
the spectroscopic element includes a diffraction grating.

4. The light source apparatus according to any one of claims 1 to 3, wherein
the controller changes a pattern of displacement of the plurality of grating elements with respect to the base part using the spatial phase modulating element from a first pattern to a second pattern, and thereby switches from a state in which the part of the wavelengths includes a first wavelength to a state in which the part of the wavelengths includes a second wavelength different from the first wavelength.

5. The light source apparatus according to any one of claims 1 to 3, wherein
the part of the wavelengths includes a plurality of wavelengths being different and apart from each other.

6. The light source apparatus according to claim 5, wherein
the controller changes a pattern of displacement of the plurality of grating elements with respect to the base part using the spatial phase modulating element from a first pattern to a second pattern, and thereby switches from a state in which the plurality of wavelengths include a first-A wavelength and a first-B wavelength to a state in which the plurality of wavelengths include a second-A wavelength different from the first-A wavelength and a second-B wavelength different from the first-B wavelength.

7. The light source apparatus according to any one of claims 1 to 6, further comprising:
a first light guide part;
an optical path change optical system; and
a second light guide part, wherein
the first light guide part guides the light released from the optical amplifier toward the optical path change optical system,
the optical path change optical system guides the light that has been released from the optical amplifier and has passed through the first light guide part toward the spectroscopic element, and guides the light having the part of the wavelengths generated in the spectroscopic element according to the diffracted light emitted from the spatial phase modulating element to the second light guide part, and
the second light guide part includes a first light output part configured to output a part of the light out of the light guided to the second light guide part by the optical path change optical system to an outside of the second light guide part, and a light guide portion configured to guide a rest of the light except the part of the light out of the light guided to the second light guide part by the optical path change optical system toward the optical amplifier.

8. The light source apparatus according to any one of claims 1 to 6, further comprising:
a third light guide part configured to guide the light released from a first end surface of the optical amplifier toward the spectroscopic element, and guide the light having the part of the wavelengths generated in the spectroscopic element according to the diffracted light emitted from the spatial phase modulating element toward the first end surface of the optical amplifier; and
a partially reflecting optical system configured to allow a part of the light out of the light released from a second end surface of the optical amplifier to be transmitted through the partially reflecting optical system and output the part of the light, and reflect a rest of the light except the part of the light out of the light released from the second end surface of the optical amplifier toward the second end surface.

9. The light source apparatus according to any one of claims 1 to 8, wherein
the plurality of grating elements include a plurality of ribbon-like parts,
each of the plurality of ribbon-like parts has an elongated ribbon-like shape extending along a first direction and flexibility, and includes a reflection part including a light reflecting surface on an opposite side of the base part,
the plurality of ribbon-like parts are arrayed along a second direction perpendicular to the first direction,
the reflection part of each of the plurality of ribbon-like parts faces the base part across a space,
each of the plurality of ribbon-like parts includes a connection part connected to the base part at both end portions in the first direction,
the base part includes an electrode facing the reflection part, and
the controller adjusts a potential difference to be applied between the reflection part of each of the plurality of ribbon-like parts and the electrode, and thereby deflects the plurality of ribbon-like parts using an electrostatic force between the reflection part of each of the plurality of ribbon-like parts and the electrode, and controls displacement of the reflection part of each of the plurality of ribbon-like parts with respect to the base part.

10. The light source apparatus according to any one of claims 1 to 8, wherein
the spatial phase modulating element includes a plurality of reflective elements arrayed in a matrix shape,
each of the plurality of reflective elements includes a movable reflection part facing the base part across a space and including a light reflecting surface on an opposite side of the base part, and a support part being configured to support each of a plurality of portions of the movable reflection part, being connected to the base part, and having flexibility,
the plurality of grating elements include the movable reflection part of each of the plurality of reflective elements,
the base part includes an electrode facing the movable reflection part, and
in each of the plurality of reflective elements, the controller adjusts a potential difference to be applied between the movable reflection part and the electrode and thereby deflects the support part using an electrostatic force between the movable reflection part and the electrode, and controls displacement of the movable reflection part with respect to the base part.
